# EUROPEAN PATENT SPECIFICATION

(11) **EP 3 926 646 B1**
(45) Date of publication and mention of the grant of the patent: **08.07.2026**
(21) Application number: 20771138.3
(22) Date of filing: 02.03.2020
(51) Int. Cl.: H01C 1/144, H01C 13/00, G01R 1/20, H01C 17/28, H01C 7/06

(54) **SHUNT RESISTOR AND MANUFACTURING METHOD THEREFOR**
SHUNT-WIDERSTAND UND HERSTELLUNGSVERFAHREN DAFÜR
RÉSISTANCE DE DÉRIVATION ET SON PROCÉDÉ DE FABRICATION

(30) Priority: 08.03.2019 JP 2019042373
(43) Date of publication of application: 22.12.2021
(60) Divisional application: 23180553.2
(73) Proprietor: Suncall Corporation, Kyoto-shi, Kyoto 615-8555 (JP)
(72) Inventor: MURAKAMI, Kenji, kyoto-shi, Kyoto 615-8555 (JP); MUGISHIMA, Akio, kyoto-shi, Kyoto 615-8555 (JP)
(74) Representative: Isarpatent
(86) International application number: PCT/JP2020/008610
(87) International publication number: WO 2020/184247

(56) References cited:
- EP-A1- 2 474 008
- WO-A1-2018/229817
- DE-A1- 102010 035 485
- DE-T5- 112015 001 789
- JP-A- 2009 244 065
- JP-A- 2013 504 213
- JP-A- 2013 536 424
- JP-A- 2016 213 367
- JP-A- 2017 208 474
- US-B2- 8 970 340

## Description

### FIELD OF THE INVENTION

The present invention relates to a shunt resistor used for current value detection and a manufacturing method therefor.

### BACKGROUND ART

A shunt resistor is inserted in series to an electric circuit whose current value is to be detected and used in detecting the current value of the circuit on the basis of a voltage value measured by measuring a voltage difference between the opposite sides of the shunt resistor in a current flowing direction and a resistance value of the shunt resistor, the resistance value being previously set to a predetermined value.

For example, Patent Literature 1 listed below discloses a shunt resistor including a resistive element such as an Ni-Cr-based alloy, and first and second conductors such as Cu, the first and second conductors being joined to the respective sides of the resistive elements in a current flowing direction. Each of the first and second conductors is separated into a current region and a voltage region by a slit.

In the shunt resistor, the current regions of the first and second conductors function as input/output connection regions to be connected to a circuit whose current value is to be detected, and the voltage regions of the first and second conductors function as detection terminal regions for voltage detection.

It is desirable for the shunt resistor to accurately make a resistance value between the detection terminal regions equal to a predetermined resistance value while minimizing power loss caused by the shunt resistor.

In view of the above point, in the shunt resistor described in Patent Literature 1, the position of the slit is set so that the width of the voltage region (the length in a width direction perpendicular to the current flowing direction) is shorter than the width of the current region.

However, the slit extends from an outer end face of the conductor, the outer end face being located opposite to the resistive element, toward an inner end face of the conductor, the inner end face serving as a face abutting against the resistive element, and terminates midway before the inner end face.

That is, in the shunt resistor, the conductor includes, in addition to the current region and the voltage region separated by the slit, a coupling region that couples the current region and the voltage region at a position where the slit is not present.

In such a configuration, the resistance value between the voltage regions of the first and second conductors is affected by a resistance value of the current region and a resistance value of the coupling region in addition to a resistance value of the resistive element. Thus, it is difficult to accurately obtain the current value of the detection target circuit on the basis of the measured voltage between the voltage regions of the first and second conductors.

Moreover, in the shunt resistor described in Patent Literature 1, the slit is open on the outer end face of the conductor, and outer ends of the current region and the voltage region are free ends. Thus, there is also a problem of weak strength against external stress.

Furthermore, in the configuration described in Patent Literature 1, it is necessary for the slit to have a certain degree of width to prevent the passage of current from the current region to the voltage region through the slit. Thus, there is also a problem of difficulty in downsizing.

### PRIOR ART DOCUMENT

### Patent Literature

Patent Literature 1: U.S. Patent No. 5,999,085
Patent Literature 2: WO 2018/229817 A1
Patent Literature 3: US 8,970,340 B2
Patent Literature 4: EP 2 474 008 A1
Patent Literature 5: DE 11 2015 001789 T5
Patent Literature 6: DE 10 2010 035485 A1

### SUMAARY OF THE INVENTION

The present invention has been made in view of the above prior art, and a first object thereof is to provide a shunt resistor including first and second conductors jointed to the respective ends of a resistive element in a current flowing direction, the shunt resistor being capable of making a resistance value between voltage regions of the first and second conductors equal to a resistance value of the resistive element as accurately as possible while ensuring sufficient mechanical strength without increasing size.

A shunt resistor according to the present invention is provided as defined by independent claim 1. The shunt resistor includes: a resistive element having a plate-like shape, the resistive element having a first joint face and a second joint face respectively located on one side and the other side in a longitudinal direction corresponding to a current flowing direction and having a predetermined resistance value; a first conductor having an inner end face joined to the first joint face; a second conductor having an inner end face joined to the second joint face; a first slit separating the first conductor into a first current region and a first voltage region; a first insulating resin filling the first slit; a second slit separating the second conductor into a second current region and a second voltage region; and a second insulating resin filling the second slit, wherein the first slit has a first end on one end side, the first end being open on the inner end face of the first conductor so that the first current region and the first voltage region both have a region joined to the first joint face, and the second slit has a first end on one end side, the first end being open on the inner end face of the second conductor so that the second current region and the second voltage region both have a region in contact with the second joint face. A second end on the other end side of the first slit is open on the inner end face at a position that makes a joint area between the first voltage region and the resistive element smaller than a joint area between the first current region and the resistive element, and a second end on the other end side of the second slit is open on the inner end face at a position that makes a joint area between the second voltage region and the resistive element smaller than a joint area between the second current region and the resistive element.

The shunt resistor according to the present invention makes it possible to make a resistance value between voltage regions of the first and second conductors equal to a resistance value of the resistive element as accurately as possible while ensuring sufficient mechanical strength without increasing size, since the first slit filled with the first insulating resin separates the first conductor into the first current region and the first voltage region, the second slit filled with the second insulating resin separates the second conductor into the second current region and the second voltage region, the first end of the first slit is open on the inner end face, which is brought into contact with the resistive element, so that so that the first current region and the first voltage region both have a region joined to the resistive element, and the first end of the second slit is open on the inner end face, which is brought into contact with the resistive element, so that the second current region and the second voltage region both have a region joined to the resistive element.

In a case where the first conductor has an outer end face located opposite to the inner end face in the longitudinal direction, and a first side face and a second side face respectively located on one side and the other side in a width direction perpendicular to the longitudinal direction, and the second conductor has an outer end face located opposite to the inner end face in the longitudinal direction, and a first side face and a second side face respectively located on the one side and the other side in the width direction, the first slit includes a first part extending from one of the first and second ends closer to the first side face of the first conductor than the other is in such a manner as to be closer to the first side face of the first conductor toward the outer end face of the first conductor and terminating inside the first conductor, a second part extending from one of the first and second ends closer to the second side face of the first conductor than the other is in such a manner as to be closer to the second side face of the first conductor toward the outer end face of the first conductor and terminating inside the first conductor, and a coupling part coupling the first and second parts, and the second slit includes a first part extending from one of the first and second ends closer to the first side face of the second conductor than the other is in such a manner as to be closer to the first side face of the second conductor toward the outer end face of the second conductor and terminating inside the second conductor, a second part extending from one of the first and second ends closer to the second side face of the second conductor than the other is in such a manner as to be closer to the second side face of the second conductor toward the outer end face of the second conductor and terminating inside the second conductor, and a coupling part coupling the first and second parts.

in a case where the first conductor has an outer end face located opposite to the inner end face in the longitudinal direction, and a first side face and a second side face respectively located on one side and the other side in a width direction perpendicular to the longitudinal direction, and the second conductor has an outer end face located opposite to the inner end face in the longitudinal direction, and a first side face and a second side face respectively located on the one side and the other side in the width direction, a second end on the other end side of the first slit is open on one of the first and second side faces of the first conductor, a second end on the other end side of the second slit is open on one of the first and second side faces of the second conductor, the first end of the first slit is open on the inner end face of the first conductor at a position that makes a joint area between the first voltage region and the resistive element smaller than a joint area between the first current region and the resistive element, and the first end of the second slit is open on the inner end face of the second conductor at a position that makes a joint area between the second voltage region and the resistive element smaller than a joint area between the second current region and the resistive element.

In a case where the first conductor has an outer end face located opposite to the inner end face in the longitudinal direction, and a first side face and a second side face respectively located on one side and the other side in a width direction perpendicular to the longitudinal direction, and the second conductor has an outer end face located opposite to the inner end face in the longitudinal direction, and a first side face and a second side face respectively located on the one side and the other side in the width direction, a second end on the other end side of the first slit is open on the outer end face of the first conductor, a second end on the other end side of the second slit is open on the outer end face of the second conductor, the first end of the first slit is open on the inner end face of the first conductor at a position that makes a joint area between the first voltage region and the resistive element smaller than a joint area between the first current region and the resistive element, and the first end of the second slit is open on the inner end face of the second conductor at a position that makes a joint area between the second voltage region and the resistive element smaller than a joint area between the second current region and the resistive element.

Alternatively, the first and second voltage regions may be provided with connection openings constituting first and second voltage detecting connection portions, respectively.

In order to achieve the first object, it is provided a shunt resistor including: a resistive element having a plate-like shape, the resistive element having a first joint face and a second joint face respectively located on one side and the other side in a longitudinal direction corresponding to a current flowing direction and having a predetermined resistance value; a first conductor having an inner end face joined to the first joint face; a second conductor having an inner end face joined to the second joint face; a first voltage detecting connection portion provided on the first conductor and a second voltage detecting connection portion provided on the second conductor; a first slit penetrating the first conductor from an upper face through a lower face; a first insulating resin filling the first slit; a second slit penetrating the second conductor from an upper face through a lower face; and a second insulating resin filling the second slit, wherein the first slit is disposed in such a manner as to overlap the first voltage detecting connection portion and be shorter than half a width of the first conductor in a width direction perpendicular to the longitudinal direction on a side farther away from the resistive element than the first voltage detecting connection portion is in the longitudinal direction, and the second slit is disposed in such a manner as to overlap the second voltage detecting connection portion and be shorter than half a width of the second conductor in a width direction perpendicular to the longitudinal direction on a side farther away from the resistive element than the second voltage detecting connection portion is in the longitudinal direction.

The shunt resistor according to an embodiment of the present invention makes it possible to make a resistance value between voltage regions of the first and second conductors equal to a resistance value of the resistive element as accurately as possible while ensuring sufficient mechanical strength without increasing size, since the first conductor with the first voltage detecting connection portion is formed with the first slit filled with the first insulating resin, the second conductor with the second voltage detecting connection portion is formed with the second slit filled with the second insulating resin, the first slit is disposed in such a manner as to overlap the first voltage detecting connection portion and be shorter than half a width of the first conductor in a width direction perpendicular to the longitudinal direction on a side farther away from the resistive element than the first voltage detecting connection portion is in the longitudinal direction, and the second slit is disposed in such a manner as to overlap the second voltage detecting connection portion and be shorter than half a width of the second conductor in a width direction perpendicular to the longitudinal direction on a side farther away from the resistive element than the second voltage detecting connection portion is in the longitudinal direction.

In a case where the first conductor has an outer end face located opposite to the inner end face in the longitudinal direction, and a first side face and a second side face respectively located on one side and the other side in a width direction perpendicular to the longitudinal direction, and the second conductor has an outer end face located opposite to the inner end face in the longitudinal direction, and a first side face and a second side face respectively located on the one side and the other side in the width direction, the first slit is preferably formed so as to have a first end on one end side that is open on one of the first and second side faces of the first conductor, and the second slit is preferably formed so as to have a first end on one end side that is open on one of the first and second side faces of the second conductor.

Each of the first and second conductors may preferably include a fastening hole.

### BRIEF DESCRIPTION OF THE DRAWINGS

[FIG. 1]

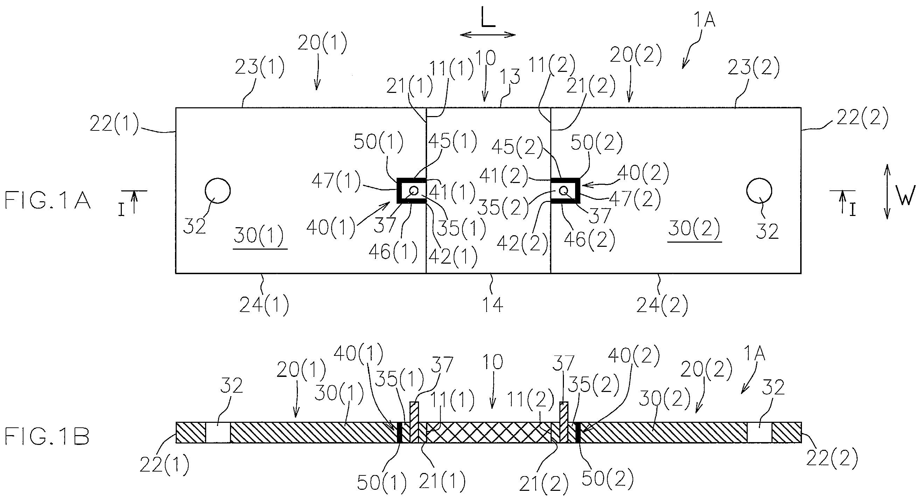

   Figs. 1A and 1B are a plan view of a shunt resistor according to a first embodiment of the present invention and a sectional view taken along line I-I in Fig. 1A.
[FIG. 2]

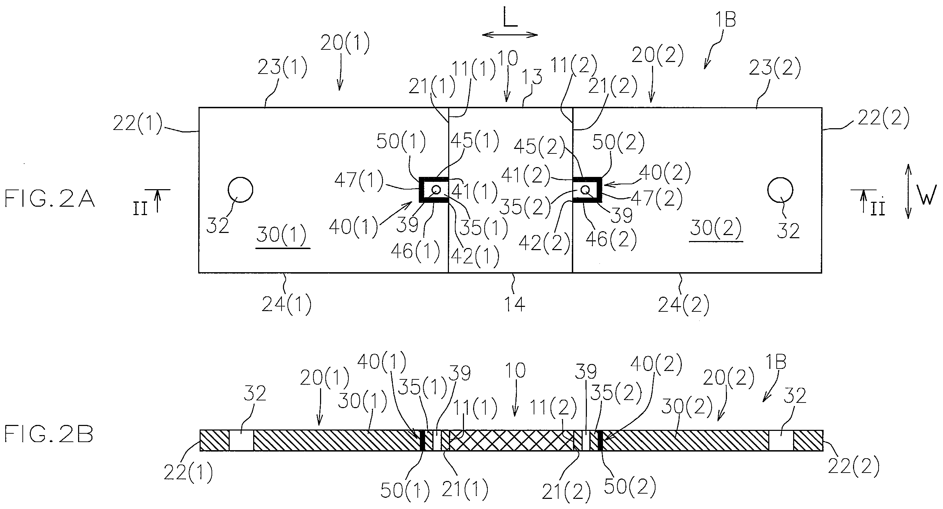

   Figs. 2A and 2B are a plan view of a shunt resistor according to a first modification of the first embodiment and a sectional view taken along line II-II in Fig. 2A.
[FIG. 3]

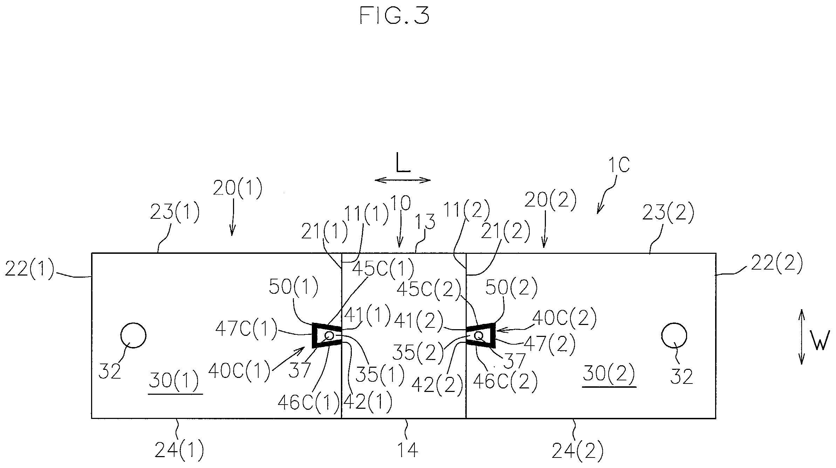

   Fig. 3 is a plan view of a shunt resistor according to a second modification of the first embodiment.
[FIG. 4]

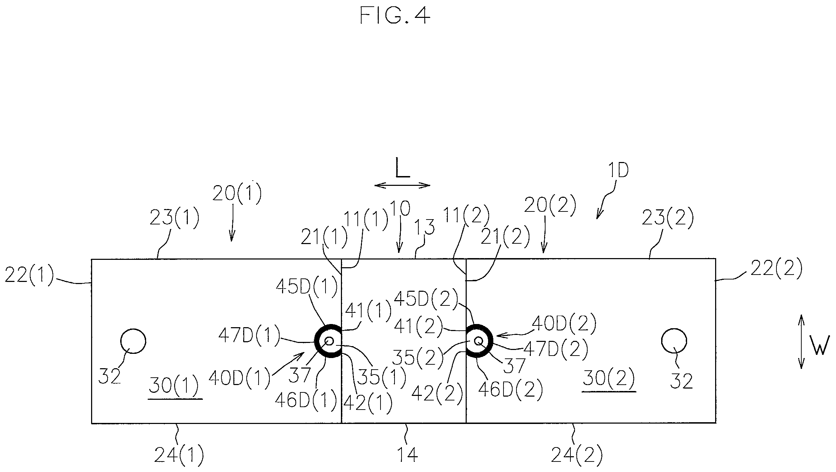

   Fig. 4 is a plan view of a shunt resistor according to a fourth modification of the first embodiment.
[FIG. 5]

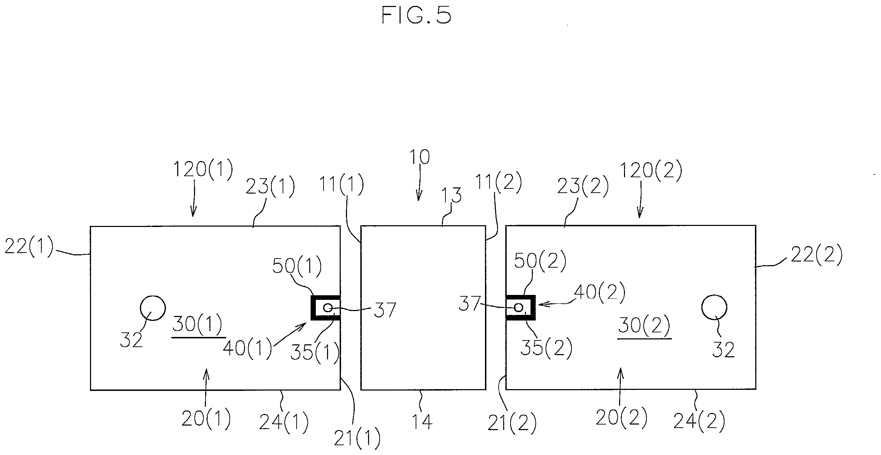

   Fig. 5 is a plan view showing one step in a first manufacturing method for the shunt resistor according to the first embodiment.
[FIG. 6]

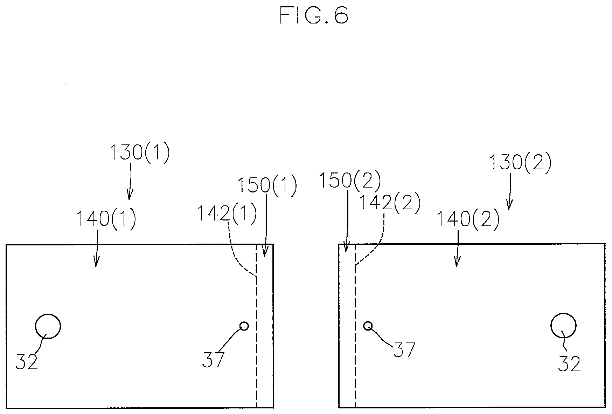

   Fig. 6 is a plan view showing a step of preparing first and second conductive metal plates in the first manufacturing method for the shunt resistor according to the first embodiment.
[FIG. 7]

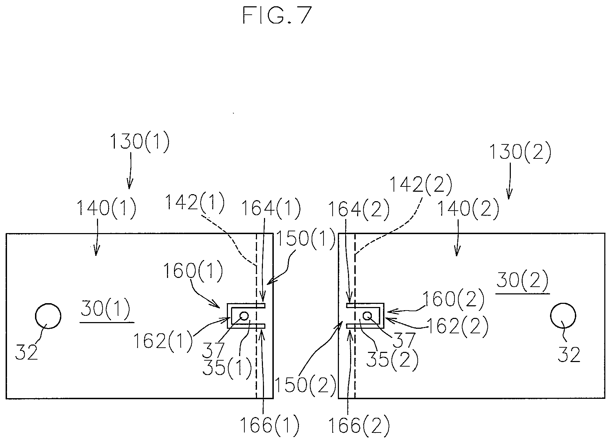

   Fig. 7 is a plan view showing a step of forming first and second through holes on the first and second conductive metal plates, respectively.
[FIG. 8]

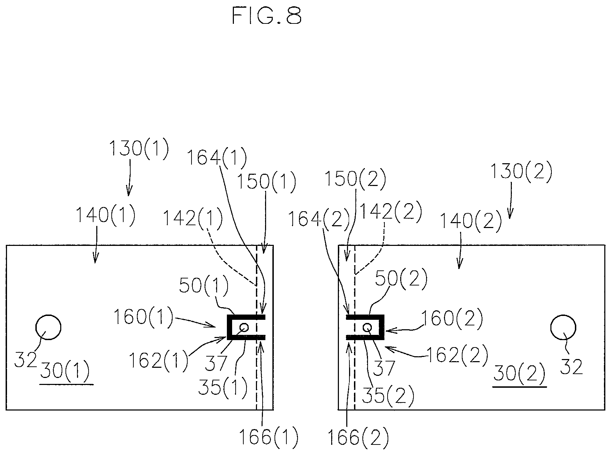

   Fig. 8 is a plan view showing a step of filling the first and second through holes with first and second insulating resin, respectively.
[FIG. 9]

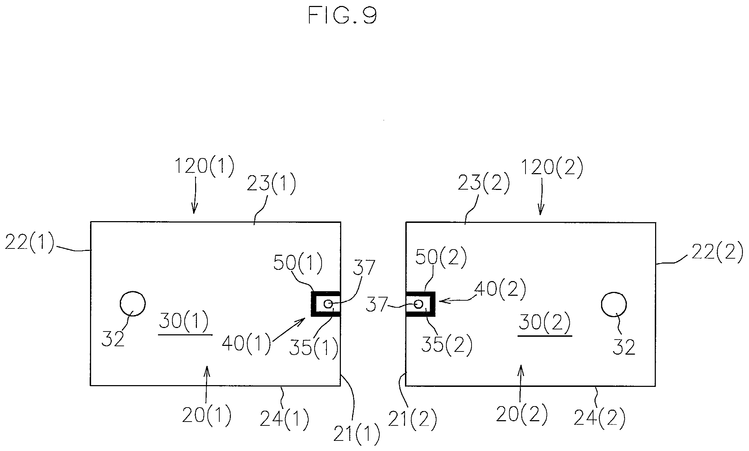

   Fig. 9 is a plan view showing a step of cutting the first and second conductors in the shunt resistor according to the first embodiment, out of the first and second conductive metal plates, respectively.
[FIG. 10]

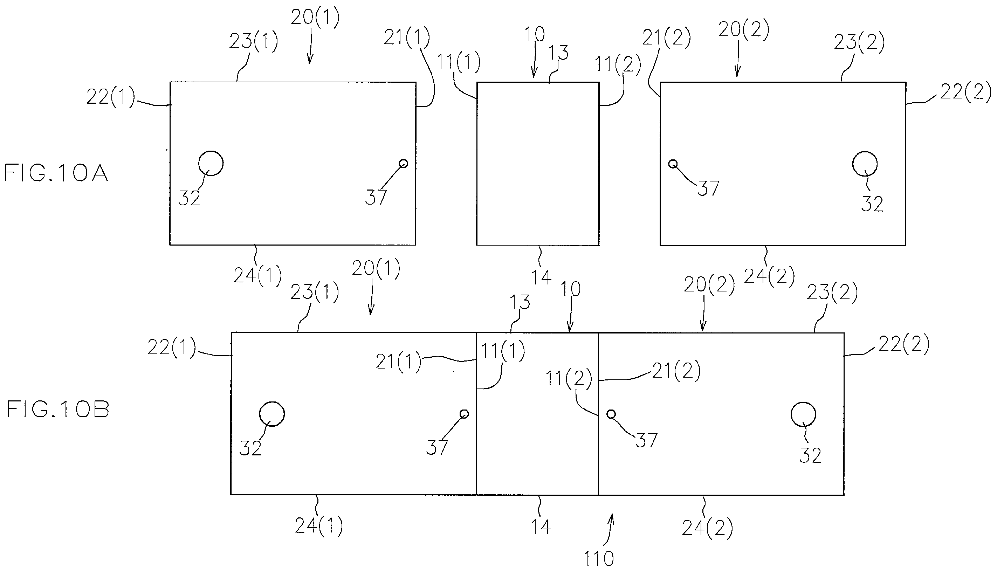

   Fig. 10A is a plan view showing a step of preparing a resistive element, a first conductor and a second conductor in a second manufacturing method for the shunt resistor according to the first embodiment, and Fig. 10B is a plan view showing a step of joining the first and second conductors with the resistive element.
[FIG. 11]

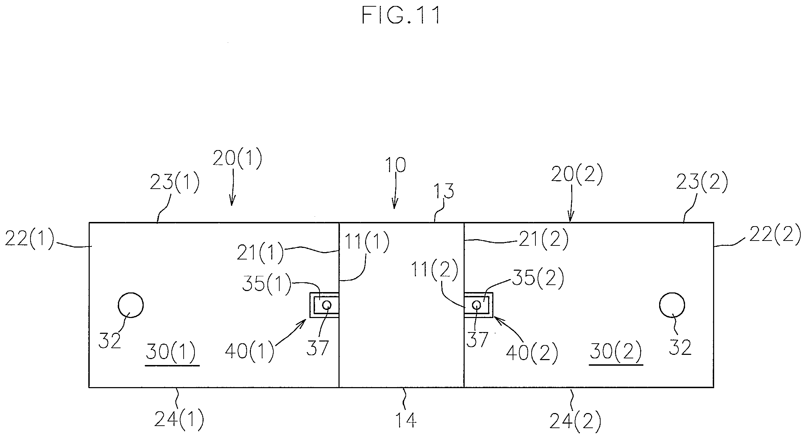

   Fig. 11 is a plan view showing a slit forming step in the second manufacturing method.
[FIG. 12]

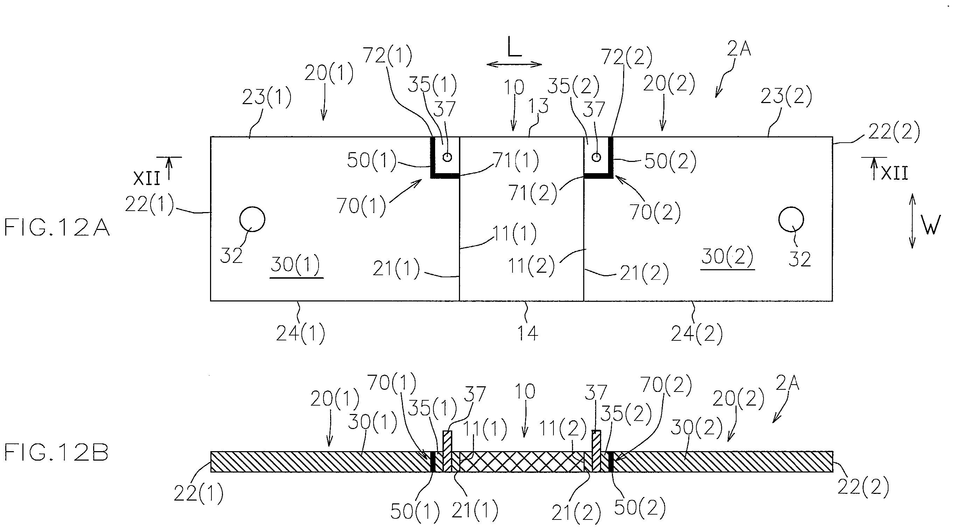

   Fig. 12A and 12B are a plan view of a shunt resistor according to a second embodiment of the present invention and a sectional view taken along line XII-XII in Fig. 12A, respectively.
[FIG. 13]

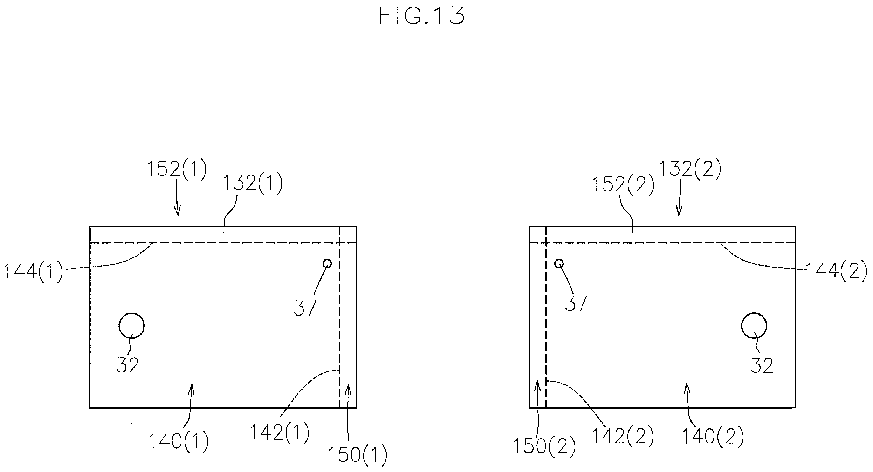

   Fig. 13 is a plan view showing a step of preparing first and second conductive metal plates in a manufacturing method for the shunt resistor according to the second embodiment.
[FIG. 14]

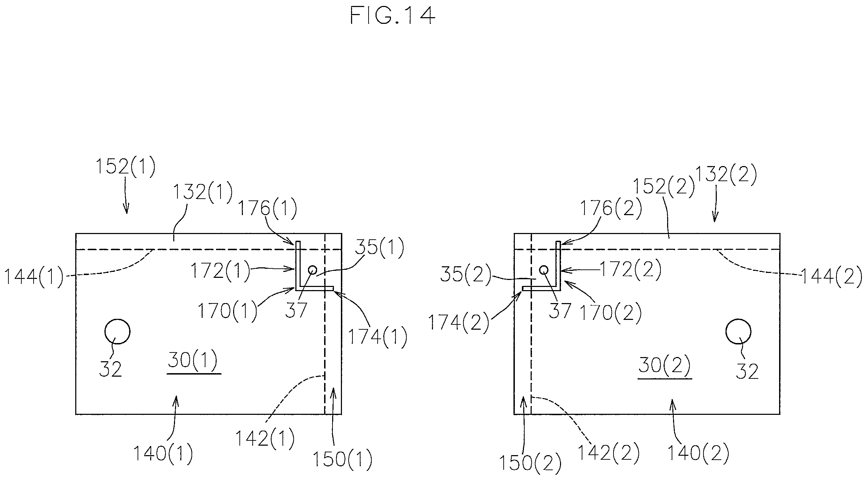

   Fig. 14 is a plan view showing first and second through hole forming steps in the manufacturing method for the shunt resistor according to the second embodiment.
[FIG. 15]

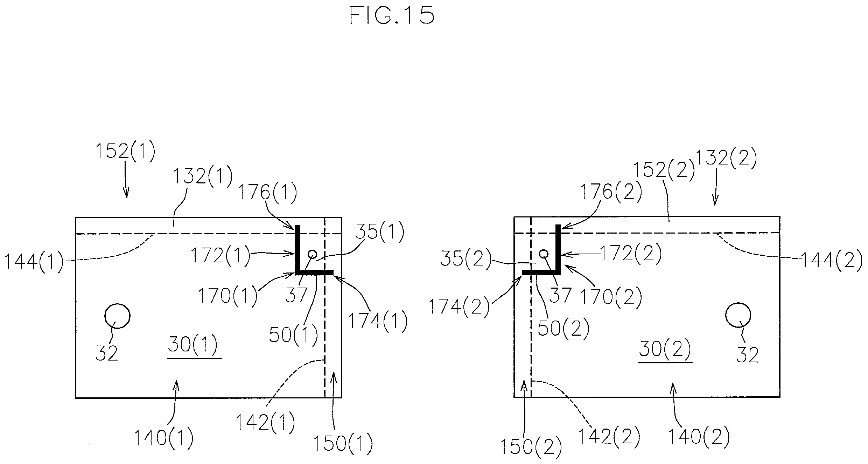

   Fig. 15 is a plan view showing first and second resin forming steps in the manufacturing method for the shunt resistor according to the second embodiment.
[FIG. 16]

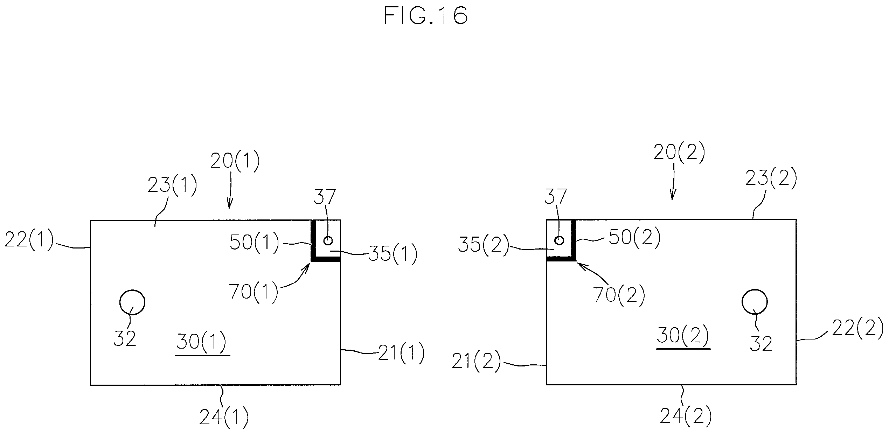

   Fig. 16 is a plan view showing a cutting step in the manufacturing method for the shunt resistor according to the second embodiment.
[FIG. 17]

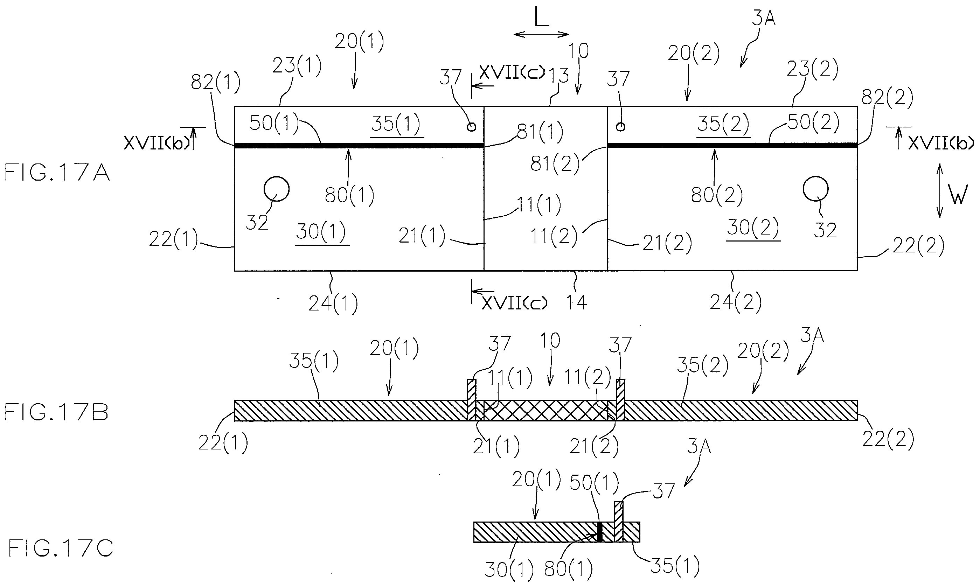

   Figs. 17A to 17C are a plan view of a shunt resistor according to a third embodiment of the present invention, a sectional view taken along line XVII(a)-XVII(a) in Fig. 17A, and a sectional view taken along line XVII(c)-XVII(c) in Fig. 17A, respectively.
[FIG. 18]

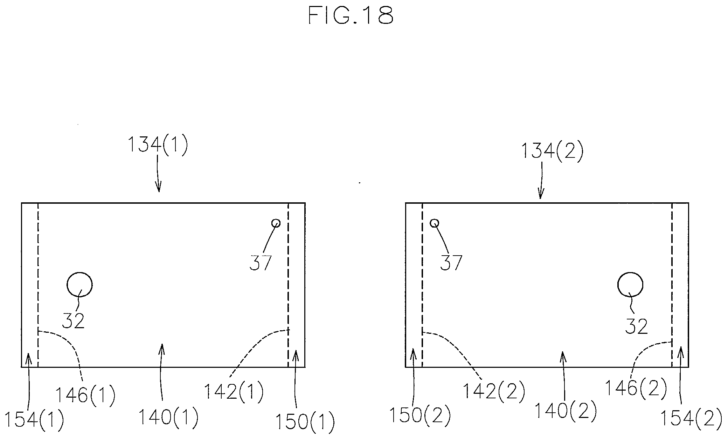

   Fig. 18 is a plan view showing a step of preparing first and second conductive metal plates in a manufacturing method for the shunt resistor according to the third embodiment.
[FIG. 19]

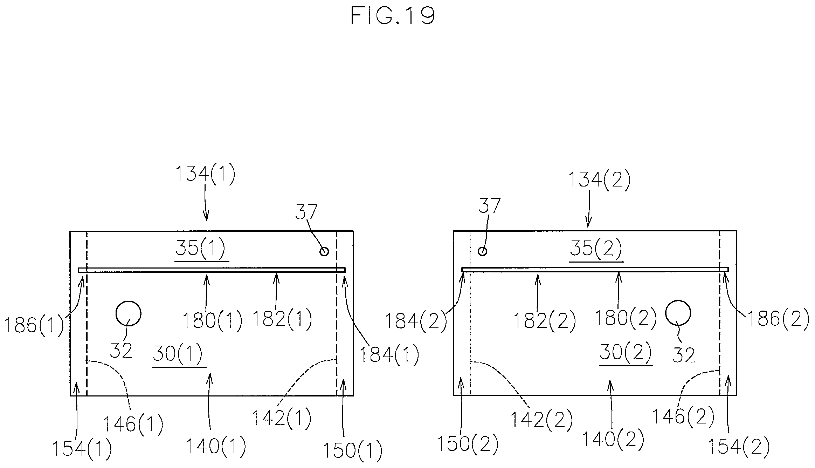

   Fig. 19 is a plan view showing first and second through hole forming steps in the manufacturing method for the shunt resistor according to the third embodiment.
[FIG. 20]

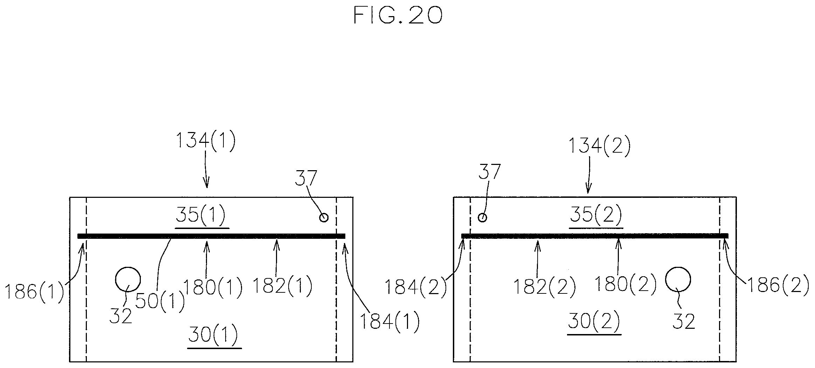

   Fig. 20 is a plan view showing first and second resin forming steps in the manufacturing method for the shunt resistor according to the third embodiment.
[FIG. 21]

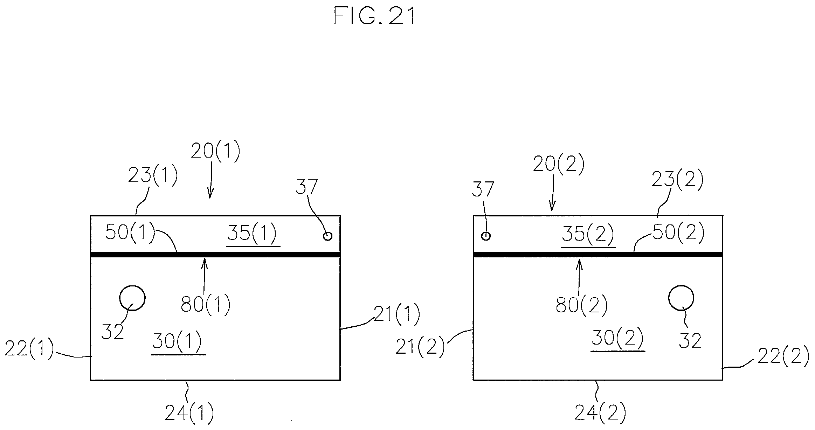

   Fig. 21 is a plan view showing a cutting step in the manufacturing method for the shunt resistor according to the third embodiment.
[FIG. 22]

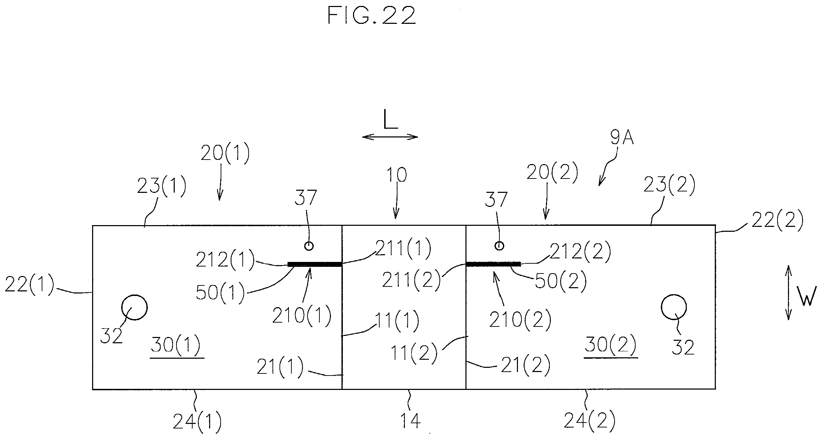

   Fig. 22 is a plan view of a shunt resistor according to a first reference example.
[FIG. 23]

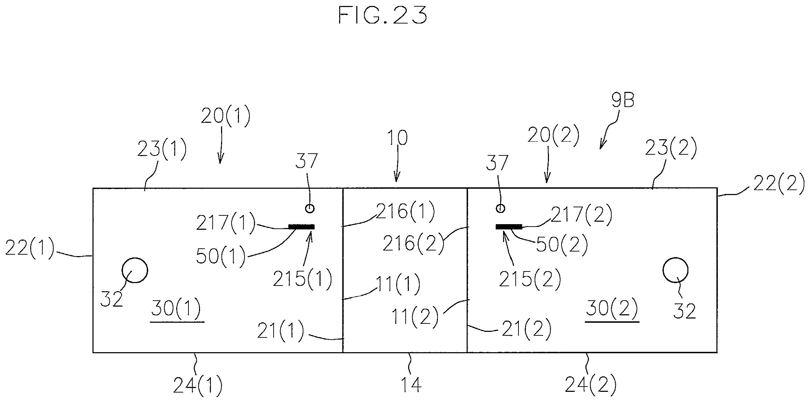

   Fig. 23 is a plan view of a shunt resistor according to a second reference example.
[FIG. 24]

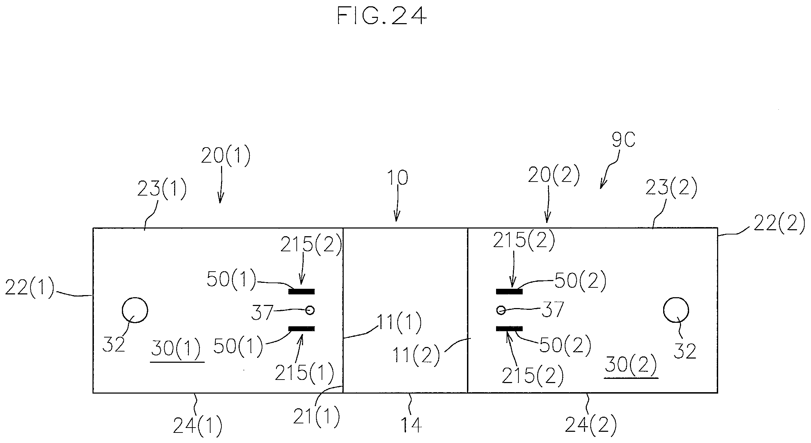

   Fig. 24 is a plan view of a shunt resistor according to a third reference example.
[FIG. 25]

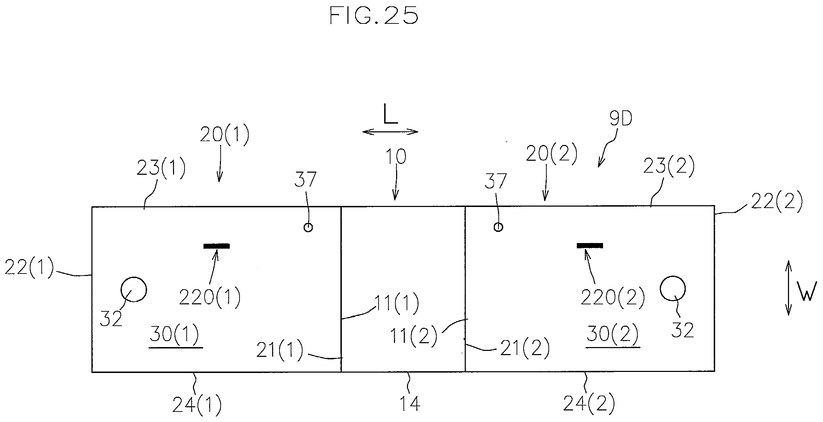

   Fig. 25 is a plan view of a shunt resistor according to a fourth reference example.
[FIG. 26]

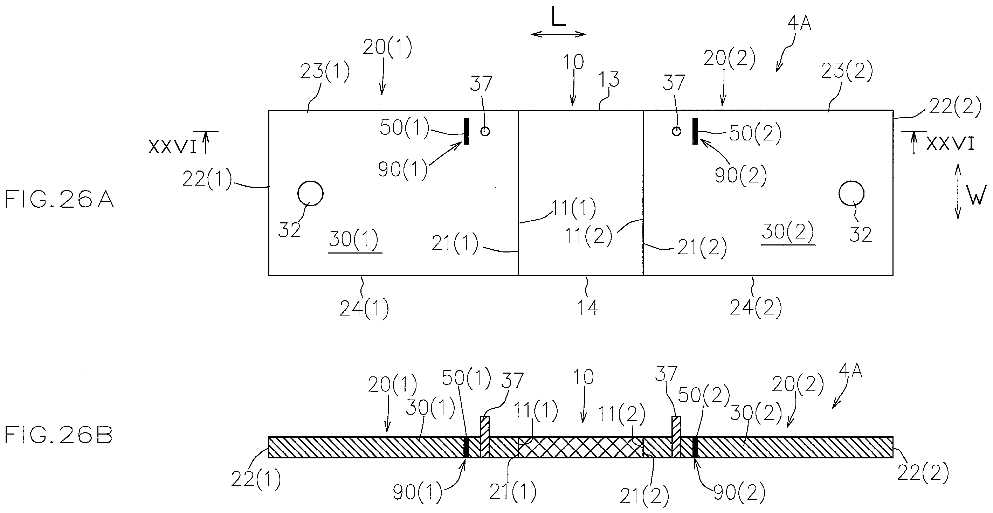

   Figs. 26A and 26B are a plan view of a shunt resistor according to a fourth embodiment of the present invention and a sectional view taken along line XXVI-XXVI in Fig. 26A.
[FIG. 27]

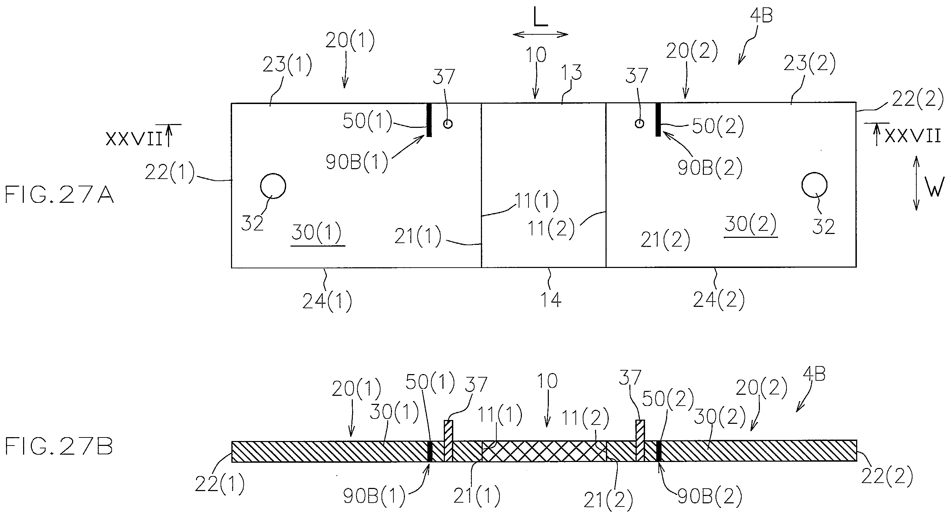

   Figs. 27A and 27B are a plan view of a shunt resistor according to a modification of the fourth embodiment of the present invention and a sectional view taken along line XXVII-XXVII in Fig. 27A.

### EMBODIMENT FOR CARRYING OUT THE INVENTION

### First Embodiment

Hereinbelow, an embodiment of a shunt resistor according to the present invention will be described with reference to the accompanying drawings.

Fig. 1A is a plan view of a shunt resistor 1A according to the present embodiment.

Fig. 1B is a sectional view taken along line I-I in Fig. 1A

The shunt resistor 1A is capable of measuring a voltage value between the opposite sides of the shunt resistor 1A in a current flowing direction in a state where the shunt resistor 1A is inserted in series to an electric circuit whose current value is to be detected and used to recognize the current value of the electric circuit on the basis of a resistance value of the shunt resistor 1A, the resistance value being previously set to a predetermined value, and the voltage value between the opposite sides of the shunt resistor 1A in the current flowing direction.

Specifically, as illustrated in Figs. 1A and 1B, the shunt resistor 1A includes a resistive element 10 set to a desired resistance value, and first and second conductors 20(1) and 20(2) formed of a metal plate material having a higher conductivity than the resistive element 10.

As illustrated in Figs. 1A and 1B, the resistive element 10 includes first and second joint faces 11(1) and 11(2) respectively facing one side and the other side in a longitudinal direction L corresponding to the current flowing direction and first and second side faces 13 and 14 respectively facing one side and the other side in a width direction W perpendicular to the longitudinal direction L.

The resistive element 10 is preferably formed of, for example, a plate material such as a Cu-Mn-based alloy, an Ni-Cr-based alloy, or a Cu-Ni-based alloy.

The first conductor 20(1) has an inner end face 21(1) facing the resistive element 10, an outer end face 22(1) located opposite to the inner end face 21(1) in the longitudinal direction, and a first side face 23(1) and a second side face 24(1) respectively located on the one side and the other side in the width direction.

Similarly, the second conductor 20(2) has an inner end face 21(2) facing the resistive element 10, an outer end face 22(2) located opposite to the inner end face 21(2) in the longitudinal direction L, and a first side face 23(2) and a second side face 24(2) respectively located on the one side and the other side in the width direction W.

The first and second conductors 20(1) and 20(2) are preferably formed of, for example, a metal plate material having a high conductivity, such as Cu.

The inner end face 21(1) of the first conductor 20(1) is joined to the first joint face 11(1) in an abutting state. The inner end face 21(2) of the second conductor 20(2) is jointed to the second joint face 11(2) in an abutting state.

The joining of the inner end face 21(1) of the first conductor 20(1) and the first joint face 11(1) is performed by, for example, welding by applying an electron beam or laser to the faces in an abutting state from one side and/or the other side in a plate-thickness direction.

Similarly, the joining of the inner end face 21(2) of the second conductor 20(2) and the second joint face 11(2) is performed by, for example, welding by applying an electron beam or laser to the faces in an abutting state from one side and/or the other side in a plate-thickness direction.

As illustrated in Figs. 1A and 1B, the shunt resistor 1A according to the present embodiment further includes a first slit 40(1) separating the first conductor 20(1) into a first current region 30(1) and a first voltage region 35(1), a second slit 40(2) separating the second conductor 20(2) into a second current region 30(2) and a second voltage region 35(2), a first insulating resin 50(1) filling the first slit 40(1), and a second insulating resin 50(2) filling the second slit 40(2).

The first and second current regions 30(1) and 30(2) function as current input/output connection portions which are connected to an electric circuit whose current value is to be detected when the shunt resistor 1A is inserted in series to the electric circuit.

Note that, in the present embodiment, the first current region 30(1) includes a fastening hole 32 used in connecting the first current region 30(1) to a desired position, and the second current region 30(2) includes a fastening hole 32 used in connecting the second current region 30(2) to a desired position.

The first and second voltage regions function as detection terminals used in measuring a voltage between the opposite sides of the shunt resistor 1A in the current flowing direction in a state where the shunt resistor 1Ais inserted in series to the electric circuit.

The first slit 40(1) has a first end 41(1) located on one end side in plan view, the first end 41(1) being open on the inner end face 21(1) of the first conductor 20(1) so that the first current region 30(1) and the first voltage region 35(1) both abut against the first joint face 11(1) when the first conductor 20(1) and the resistive element 10 are joined together.

In the present embodiment, as illustrated in Fig. 1A, the first slit 40(1) has a second end 42(1) located on the other end side in plan view, the second end 42(1) being also open on the inner end face 21(1) of the first conductor 20(1).

That is, in the present embodiment, the first slit 40(1) has a squared C shape or a C shape open on the inner end face 21(1) of the first conductor 20(1) in plan view.

Similarly, the second slit 40(2) has a first end 41(2) located on one end side in plan view, the first end 41(2) being open on the inner end face 21(2) of the second conductor 20(2) so that the second current region 30(2) and the second voltage region 35(2) both abut against the second joint face 11(2) when the second conductor 20(2) and the resistive element 10 are joined together.

In the present embodiment, as illustrated in Fig. 1A, the second slit 40(2) has a second end 42(2) located on the other end side in plan view, the second end 42(2) being also open on the inner end face 21(2) of the second conductor 20(2).

That is, in the present embodiment, the second slit 40(2) has a squared C shape or a C shape open on the inner end face 21(2) of the second conductor 20(2) in plan view.

The first slit 40(1) is filled with the first insulating resin 50(1) so that the first voltage region 35(1) is electrically isolated from and mechanically coupled to the first current region 30(1).

Similarly, the second slit 40(2) is filled with the second insulating resin 50(2) so that the second voltage region 35(2) is electrically isolated from and mechanically coupled to the second current region 30(2).

The first and second insulating resins 50(1) and 50(2) are formed of a resin having heat resistance and insulating properties. For example, polyimide, polyamide, or epoxy is preferably used.

The shunt resistor 1A having such a configuration can prevent, as much as possible, the first and second current regions 30(1) and 30(2) from affecting a resistance value between the first and second voltage regions 35(1) and 35(2) and make the resistance value between the first and second voltage regions 35(1) and 35(2) equal to a resistance value of the resistive element 10 as accurately as possible due to the presence of the first slit 40(1) filled with the first insulating resin 50(1) and the second slit 40(2) filled with the second insulating resin 50(2).

Further, the first voltage region 35(1) is electrically insulated from and mechanically coupled to the first current region 30(1) by the first slit 40(1) filled with the first insulating resin 50(1). Similarly, the second voltage region 35(2) is electrically insulated from and mechanically coupled to the second current region 30(2) by the second slit 40(2) filled with the second insulating resin 50(2).

Thus, it is possible to obtain an electrically insulated state between the current region 30(1) and the voltage region 35(1) and between the current region 30(2) and the voltage region 35(2) without increasing the width of the first and second slits 40(1) and 40(2) and also improve the mechanical strength of the first and second voltage regions 35(1) and 35(2).

Further, in the present embodiment, as illustrated in Figs. 1A and 1B, the positions of the first and second ends 41(1) and 42(1) of the first slit 40(1) are set so that a joint area between the first voltage region 35(1) and the resistive element 10 is smaller than a joint area between the first current region 30(1) and the resistive element 10. Also, the positions of the first and second ends 41(2) and 42(2) of the second slit 40(2) are set so that a joint area between the second voltage region 35(2) and the resistive element 10 is smaller than a joint area between the second current region 30(2) and the resistive element 10.

Such a configuration makes it possible to reduce power loss caused by voltage measurement between the first and second voltage regions 35(1) and 35(2).

In the present embodiment, as illustrated in Figs. 1A and 1B, the first voltage region 35(1) includes a pin electrode 37 constituting a first voltage detecting connection portion, and the second voltage region 35(2) includes a pin electrode 37 constituting a second voltage detecting connection portion. Alternatively, as in a first modification 1B illustrated in Figs. 2A and 2B, the first and second voltage regions 35(1) and 35(2) may include connection openings 39 instead of the pin electrodes 37, and the connection openings 39 may be used as the first and second voltage detecting connection portions.

Further, in the present embodiment, as illustrated in Fig. 1A, the first slit 40(1) includes a first part 45(1) extending parallel to a longitudinal direction corresponding to the current flowing direction from the first end 41(1) toward the outer end face 22(1), a second part 46(1) extending parallel to the longitudinal direction from the second end 42(1) toward the outer end face 22(1), and a coupling part 47(1) coupling ends of the first and second parts 45(1) and 46(1), the ends being located on the side closer to the outer end face 22(1). The second slit 40(2) includes a first part 45(2) extending parallel to the longitudinal direction from the first end 41(2) toward the outer end face 22(2), a second part 46(2) extending parallel to the longitudinal direction from the second end 42(2) toward the outer end face 22(2), and a coupling part 47(2) coupling ends of the first and second parts 45(2) and 46(2), the ends being located on the side closer to the outer end face 22(2). However, it is needless to say that the present invention is not limited to such a configuration.

Fig. 3 is a plan view of a shunt resistor 1C according to a second modification of the present embodiment.

Compared to the present embodiment 1A, the second modification 1C includes first and second slits 40C(1) and 40C(2) instead of the first and second slits 40(1) and 40(2).

As illustrated in Fig. 3, the first slit 40C(1) includes a first part 45C(1) having a linear shape in plan view, the first part extending from one of the first and second ends 41(1) and 42(1) closer to the first side face 23(1) than the other is (the first end 41(1) in the illustrated configuration) in such a manner as to be closer to the first side face 23(1) toward the outer end face 22(1) of the first conductor 20(1) and terminating inside the first conductor 20(1), a second part 46C(1) having a linear shape in plan view, the second part 46C(1) extending from one of the first and second ends 41(1) and 42(1) closer to the second side face 24(1) than the other is (the second end 42(1) in the illustrated configuration) in such a manner as to be closer to the second side face 24(1) toward the outer end face 22(1) of the first conductor 20(1) and terminating inside the first conductor 20(1), and a coupling part 47C(1) coupling the first and second parts 45C(1) and 46C(1).

The second slit 40C(2) includes a first part 45C(2) having a linear shape in plan view, the first part 45C(2) extending from one of the first and second ends 41(2) and 42(2) closer to the first side face 23(2) than the other is (the first end 41(2) in the illustrated configuration) in such a manner as to be closer to the first side face 23(2) toward the outer end face 22(2) of the second conductor 20(2) and terminating inside the second conductor 20(2), a second part 46C(2) having a linear shape in plan view, the second part 46C(2) extending from one of the first and second ends 41(2) and 42(2) closer to the second side face 24(2) than the other is (the second end 42(2) in the illustrated configuration) in such a manner as to be closer to the second side face 24(2) toward the outer end face 22(2) of the second conductor 20(2) and terminating inside the second conductor 20(2), and a coupling part 47C(2) coupling the first and second parts 45C(2) and 46C(2).

Such a configuration makes it possible to increase the areas of the voltage regions 35(1) and 35(2) in plan view while preventing increase in power loss caused by increase in the joint areas between the voltage regions 35(1) and 35(2) and the resistive element 10, thereby improving flexibility in the design of the voltage detecting connection portions.

Fig. 4 is a plan view of a shunt resistor 1D according to a third modification of the present embodiment.

Compared to the second modification 1C, the third modification 1D includes first and second slits 40D(1) and 40D(2) instead of the first and second slits 40C(1) and 40C(2).

The first slit 40D(1) includes a first part 45D(1) having a curved shape in plan view, the first part 45D(1) extending from one of the first and second ends 41(1) and 42(1) closer to the first side face 23(1) of the first conductor 20(1) than the other is (the first end 41(1) in the illustrated configuration) in such a manner as to be closer to the first side face 23(1) of the first conductor 20 (1) toward the outer end face 22(1) of the first conductor 20(1) and terminating inside the first conductor 20(1), a second part 46D(1) having a curved shape in plan view, the second part 46D(1) extending from one of the first and second ends 41(1) and 42(1) closer to the second side face 24(1) than the other is (the second end 42(1) in the illustrated configuration) in such a manner as to be closer to the second side face 24(1) toward the outer end face 22(1) of the first conductor 20(1) and terminating inside the first conductor 20(1), and a coupling part 47D(1) coupling the first and second parts 45D(1) and 46D(1).

The second slit 40D(2) includes a first part 45D(2) having a curved shape in plan view, the first part 45D(2) extending from one of the first and second ends 41(2) and 42(2) closer to the first side face 23(2) than the other is (the first end 41(2) in the illustrated configuration) in such a manner as to be closer to the first side face 23(2) toward the outer end face 22(2) of the second conductor 20(2) and terminating inside the second conductor 20(2), a second part 46D(2) having a curved shape in plan view, the second part 46D(2) extending from one of the first and second ends 41(2) and 42(2) closer to the second side face 24(2) than the other is (the second end 42(2) in the illustrated configuration) in such a manner as to be closer to the second side face 24(2) toward the outer end face 22(2) of the second conductor 20(2) and terminating inside the second conductor 20(2), and a coupling part 47D(2) coupling the first and second parts 45D(2) and 46D(2).

The third modification 1D can also obtain effects similar to the effects obtained in the second modification 1C.

Note that, in the third modification 1D, although the first parts 45D(1) and 45D(2), the second parts 46D(1) and 46D(2), and the coupling parts 47D(1) and 47D(2) all have a curved shape in plan view, only one or two of these parts may be formed in a curved shape in plan view, and the other parts may be formed in a linear shape in plan view.

Next, a method for manufacturing the shunt resistor 1A will be described.

First, a first manufacturing method will be described.

The first manufacturing method includes:
a step of preparing the resistive element 10 formed of a plate material such as a Cu-Mn-based alloy, an Ni-Cr-based alloy, or a Cu-Ni-based alloy, a first conductor assembly 120(1) in which the first conductor 20(1) formed of a metal plate material such as Cu is provided with the first slit 40(1) and the first insulating resin 50(1), and a second conductor assembly 120(2) in which the second conductor 20(2) formed of a metal plate material such as Cu is provided with the second slit 40(2) and the second insulating resin 50(2) (refer to Fig 5);
a first conductor joining step of joining the inner end face 21(1) of the first conductor 20(1) of the first conductor assembly 120(1) and the first joint face 11(1) of the resistive element 10 together in an abutting state (refer to Fig. 1A); and
a second conductor joining step of joining the inner end face 21(2) of the second conductor 20(2) of the second conductor assembly 120(2) and the second joint face 11(2) of the resistive element 10 together in an abutting state (refer to Fig. 1A).

The step of preparing the first conductor assembly 120(1) includes:
a step of preparing a first conductive metal plate 130(1) such as Cu including a first conductor forming region 140(1) for forming the first conductor 20(1) and a first inner extending region 155(1) connected to the first conductor forming region 140(1) with a first inner boundary 142(1) defining the position of the inner end face 21(1) interposed therebetween (refer to Fig. 6);
a step of forming a first through hole 160(1) on the first conductive metal plate 130(1), the first through hole 160(1) penetrating the first conductive metal plate 130(1) from an upper face on one side in a thickness direction through a lower face on other side in the thickness direction and including a first slit forming part 162(1) having a plan-view shape inside the first conductor forming region 140(1) identical to a plan-view shape of the first slit 40(1) and a first end side extending part 164(1) extending from a first end of the first slit forming part 162(1) on one end side into the first inner extending region 150(1) beyond the first inner boundary 142(1) and terminating inside the first inner extending region 150(1) (refer to Fig. 7);
a step of applying coating containing an insulating resin material such as polyimide, polyamide, or epoxy to the inside of the first through hole 160(1) and curing the coating to fill the first through hole 160(1) with the first insulating resin 50(1) (refer to Fig. 8); and
a step of cutting the first conductor forming region 140(1) out of the first conductive metal plate 130(1) at a cutting line including the first inner boundary 142(1) to obtain the first conductor assembly 120(1) in which the first conductor 20(1) is provided with the first slit 40(1) and the first insulating resin 50(1) (refer to Fig. 9).

Similarly, the step of preparing the second conductor assembly 120(2) includes:
a step of preparing a second conductive metal plate 130(2) such as Cu including a second conductor forming region 140(2) for forming the second conductor 20(2) and a second inner extending region 155(2) connected to the second conductor forming region 140(2) with a second inner boundary 142(2) defining the position of the inner end face 21(2) interposed therebetween (refer to Fig. 6);
a step of forming a second through hole 160(2) on the second conductive metal plate 130(2), the second through hole 160(2) penetrating the second conductive metal plate 130(2) from an upper face on one side in a thickness direction through a lower face on other side in the thickness direction and including a second slit forming part 162(2) having a plan-view shape inside the second conductor forming region 140(2) identical to a plan-view shape of the second slit 40(2) and a first end side extending part 164(2) extending from a first end of the second slit forming part 162(2) on one end side into the second inner extending region 150(2) beyond the second inner boundary 142(2) and terminating inside the second inner extending region 150(2) (refer to Fig. 7);
a step of applying coating containing an insulating resin material such as polyimide, polyamide, or epoxy to the inside of the second through hole 160(2) and curing the coating to fill the second through hole 160(2) with the second insulating resin 150(2) by (refer to Fig. 8); and
a step of cutting the second conductor forming region 140(2) out of the second conductive metal plate 130(2) at a cutting line including the second inner boundary 142(2) to obtain the second conductor assembly 120(2) in which the second conductor 20(2) is provided with the second slit 40(2) and the second insulating resin 50(2) (refer to Fig. 9).

The through hole formation in the first and second through hole forming steps can be performed by various means such as punching and laser beam machining.

In the shunt resistor 1A according to the present embodiment, as described above, the second ends 42(1) and 42(2) of the first and second slits 40(1) and 40(2) are also open on the inner end faces 21(1) and 21(2), respectively.

Thus, as illustrated in Fig. 7, the first through hole 160(1) includes, in addition to the first slit forming part 162(1) and the first end side extending part 164(1), a second end side extending part 166(1) extending from a second end of the first slit forming part 162(1) on the other end side into the first inner extending region 150(1) beyond the first inner boundary 142(1) and terminating inside the first inner extending region 150(1).

Similarly, the second through hole 160(2) includes, in addition to the second slit forming part 162(2) and the first end side extending part 164(2), a second end side extending part 166(2) extending from a second end of the second slit forming part 162(2) on the other end side into the second inner extending region 150(2) beyond the second inner boundary 142(2) and terminating inside the second inner extending region 150(2).

The cutting step can use various means such as wire machining and laser beam machining.

The joining of the first and second conductors 20(1) and 20(2) and the resistive element 10 can be performed by various means such as welding and soldering, the welding being performed by bringing the inner end faces 21(1) and 21(2) of the conductors 20(1) and 20(2) in the conductor assemblies 120(1) and 120(2) into abut against the joint faces 11(1) and 11(2) of the resistive element 10, respectively, and applying an electron beam or laser to the abutting parts.

According to the first manufacturing method, at the stage where the first through hole 160(1) (the second through hole 160(2)) for forming the first slit 40(1) (the second slit 40(2)) is formed, the first voltage region 35(1) (the second voltage region 35(2)) and the first current region 30(1) (the second current region 30(2)) are coupled to each other through the first inner extending region 150(1) (the second inner extending region 150(2)).

Thus, the first through hole 160(1) (the second through hole 160(2)) for forming the first slit 40(1) (the second slit 40(2)) can be formed with an accurate width as designed.

Further, since both end sides of the first through hole 160(1) (the second through hole 160(2)) are coupled, it is possible to efficiently perform an operation of filling the first through hole 160(1) (the second through hole 160(2)) with the first insulating resin 50(1) (the second insulating resin 50(2)).

Note that the formation of the first and second voltage detecting connection portions (the pin electrodes 37 or the connection openings 39) on the first and second voltage regions 35(1) and 35(2) and the formation of the fastening holes 32 on the first and second current regions 30(1) and 30(2) can be performed at any stage.

That is, the first and second voltage detecting connection portions and the fastening holes 32 can be formed when the first and second conductive metal plates 130(1) and 130(2) are prepared as illustrated in Fig. 6 or after completion of the first and second conductor assemblies 120(1) and 120(2).

Alternatively, these can be formed after the first conductor joining step and the second conductor joining step.

The first conductor joining step and the second conductor joining step can be simultaneously performed or performed in any order.

Next, a second manufacturing method for the shunt resistor 1A will be described.

The second manufacturing method includes:
a step of preparing the resistive element 10 formed of a plate material such as a Cu-Mn-based alloy, an Ni-Cr-based alloy, or a Cu-Ni-based alloy, and the first conductor 20(1) and the second conductor 20(2) which are formed of a metal plate material such as Cu (refer to Fig 10A);
a first conductor joining step of joining the inner end face 21(1) of the first conductor 20(1) and the first joint face 11(1) of the resistive element 10 together in an abutting state (refer to Fig. 10A);
a second conductor joining step of joining the inner end face 21(2) of the second conductor 20(2) and the second joint face 11(2) of the resistive element 10 together in an abutting state (refer to Fig. 10A);
a slit forming step of forming the first and second slits 40(1) and 40(2) on a preassembly 110 (refer to Fig. 10B) obtained by joining the first and second conductors 20(1) and 20(2) to the resistive element 10 (refer to Fig. 11); and
a resin forming step of filling the first and second slits 40(1) and 40(2) with insulating resin materials such as polyimide, polyamide, or epoxy for forming the first and second insulating resins 50, respectively, and curing the insulating resin materials (refer to Figs. 1A and 1B).

The joining in the first conductor joining step and the second conductor joining step can be performed by, for example, welding by applying an electron beam or laser or soldering.

The first conductor joining step and the second conductor joining step can be simultaneously performed or performed in any order.

The slit formation in the slit forming step may be performed by various means such as punching and laser beam machining.

Note that the formation of the first and second voltage detecting connection portions (the pin electrodes 37 or the connection openings 39) on the first and second voltage regions 35(1) and 35(2) and the formation of the fastening holes 32 on the first and second current regions 30(1) and 30(2) can be performed at any stage.

That is, the first and second voltage detecting connection portions and the fastening holes 32 can be previously formed on the first and second conductors 20(1) and 20(2) before the first conductor joining step and the second conductor joining step or formed on the preassembly 110 before or after the slit forming step.

Alternatively, these can be formed after the resin forming step.

### Second Embodiment

Hereinbelow, another embodiment of the method for manufacturing the shunt resistor according to the present invention will be described with reference to the accompanying drawings.

Fig. 12A is a plan view of a shunt resistor 2A according to the present embodiment. Fig. 12B is a sectional view taken along line XII-XII in Fig. 12A.

Note that, in the drawings, members same as those in the first embodiment will be designated by the same reference signs as in the first embodiment to appropriately omit description thereof.

The shunt resistor 2A according to the present embodiment differs from the shunt resistor 1A according to the first embodiment only in that the shunt resistor 2A includes first and second slits 70(1) and 70(2) instead of the first and second slits 40(1) and 40(2).

As illustrated in Fig. 12A, the first slit 70(1) has a first end 71(1) open on the inner end face 21(1) of the first conductor 20(1) and a second end 72(1) open on one of the first and second side faces 23(1) and 24(1) of the first conductor 20(1) (the first side face 23(1) in the illustrated configuration).

The second slit 70(2) has a first end 71(2) open on the inner end face 21(2) of the second conductor 20(2) and a second end 72(2) open on one of the first and second side faces 23(2) and 24(2) of the second conductor 20(2) (the first side face 23(2) in the illustrated configuration).

The shunt resistor 2A having such a configuration can also make the resistance value between the first and second voltage regions 35(1) and 35(2) equal to the resistance value of the resistive element 10 as accurately as possible.

Moreover, it is possible to obtain an electrically insulated state between the current region 30(1) and the voltage region 35(1) and between the current region 30(2) and the voltage region 35(2) without increasing the width of the first and second slits 70(1) and 70(2) and also improve the mechanical strength of the first and second voltage regions 35(1) and 35(2) using the insulating resins 50(1) and 50(2), respectively.

Furthermore, in the present embodiment, as illustrated in Fig. 12A, the first end 71(1) of the first slit 70(1) is open on the inner end face 21(1) of the first conductor 20(1) at a position that makes the joint area between the first voltage region 35(1) and the resistive element 10 smaller than the joint area between the first current region 30(1) and the resistive element 10, and the first end 71(2) of the second slit 70(2) is open on the inner end face 21(2) of the second conductor 20(2) at a position that makes the joint area between the second voltage region 35(2) and the resistive element 10 smaller than the joint area between the second current region 30(2) and the resistive element 10.

Such a configuration makes it possible to reduce power loss caused by voltage measurement between the first and second voltage regions 35(1) and 35(2).

Next, a method for manufacturing the shunt resistor 2A will be described.

The manufacturing method differs from the first manufacturing method for the shunt resistor 1A according to the first embodiment in that first and second conductive metal plates 132(1) and 132(2) are used instead of the first and second conductive metal plates 130(1) and 130(2).

The first conductive metal plate 132(1) includes, in addition to the first conductor forming region 140(1) and the first inner extending region 150(1), a first lateral extending region 152(1) connected to the first conductor forming region 140(1) with a first lateral boundary 144(1) interposed therebetween (refer to Fig. 13).

Similarly, the second conductive metal plate 132(2) includes, in addition to the second conductor forming region 140(2) and the second inner extending region 150(2), a second lateral extending region 152(2) connected to the second conductor forming region 140(2) with a second lateral boundary 144(2) interposed therebetween (refer to Fig. 13).

Compared to the first manufacturing method for the shunt resistor 1A according to the first embodiment, the method for manufacturing the shunt resistor 2A forms first and second through holes 170(1) and 170(2) instead of the first and second through holes 160(1) and 160(2) (refer to Fig. 14).

As illustrated in Fig. 14, the first through hole 170(1) includes a first slit forming part 172(1) for forming the first slit 70(1), a first end side extending part 174(1) extending from a first end of the first slit forming part 172(1) on one end side into the first inner extending region 150(1) beyond the first inner boundary 142(1) and terminating inside the first inner extending region 150(1), and a second end side extending part 176(1) extending from a second end of the first slit forming part 172(1) on the other end side into the first lateral extending region 152(1) beyond the first lateral boundary 144(1) and terminating inside the first lateral extending region 152(1).

Similarly, the second through hole 170(2) includes a second slit forming part 172(2) for forming the second slit 70(2), a first end side extending part 174(2) extending from a first end of the second slit forming part 172(2) on one end side into the second inner extending region 150(2) beyond the second inner boundary 142(2) and terminating inside the second inner extending region 150(2), and a second end side extending part 176(2) extending from a second end of the second slit forming part 172(2) on the other end side into the second lateral extending region 152(2) beyond the second lateral boundary 144(2) and terminating inside the second lateral extending region 152(2).

In the method for manufacturing the shunt resistor 2A, after coating for forming the first insulating resin 50(1) (the second insulating resin 50(2)) is applied to the first through hole 170(1) (the second through hole 170(2)) and cured (refer to Fig. 15), the first conductor forming region 140(1) (the second conductor forming region 140(2)) is cut out of the first conductive metal plate 132(1) (the second conductive metal plate 132(2)) at a cutting line including the first inner boundary 142(1) (the second inner boundary 142(2)) and the first lateral boundary 144(1) (the second lateral boundary 144(2)) (refer to Fig. 16).

### Third Embodiment

Hereinbelow, another embodiment of the method for manufacturing the shunt resistor according to the present invention will be described with reference to the accompanying drawings.

Fig. 17A is a plan view of a shunt resistor 3A according to the present embodiment.

Fig. 17B is a sectional view taken along line XVII(a)-XVII(a) in Fig. 17A. Fig. 17C is a sectional view taken along line XVII(c)-XVII(c) in Fig. 17A.

Note that, in the drawings, members same as those in the first and second embodiments will be designated by the same reference signs as in the first and second embodiments to appropriately omit description thereof.

The shunt resistor 3A according to the present embodiment differs from the shunt resistor 1A according to the first embodiment only in that the shunt resistor 3A includes first and second slits 80(1) and 80(2) instead of the first and second slits 40(1) and 40(2).

As illustrated in Fig. 17A, the first slit 80(1) has a first end 81(1) open on the inner end face 21(1) of the first conductor 20(1) and a second end 82(1) open the outer end face 22(1) of the first conductor 20(1).

The second slit 80(2) has a first end 81(2) open on the inner end face 21(2) of the second conductor 20(2) and a second end 82(2) open the outer end face 22(2) of the second conductor 20(2).

The shunt resistor 3A having such a configuration can also make the resistance value between the first and second voltage regions 35(1) and 35(2) equal to the resistance value of the resistive element 10 as accurately as possible.

Moreover, it is possible to obtain an electrically insulated state between the current region 30(1) and the voltage region 35(1) and between the current region 30(2) and the voltage region 35(2) without increasing the width of the first and second slits 80(1) and 80(2) and also improve the mechanical strength of the first and second voltage regions 35(1) and 35(2).

Furthermore, in the present embodiment, as illustrated in Fig. 17A, the first end 81(1) of the first slit 80(1) is open on the inner end face 21(1) of the first conductor 20(1) at a position that makes the joint area between the first voltage region 35(1) and the resistive element 10 smaller than the joint area between the first current region 30(1) and the resistive element 10, and the first end 81(2) of the second slit 80(2) is open on the inner end face 21(2) of the second conductor 20(2) at a position that makes the joint area between the second voltage region 35(2) and the resistive element 10 smaller than the joint area between the second current region 30(2) and the resistive element 10.

Such a configuration makes it possible to reduce power loss caused by voltage measurement between the first and second voltage regions 35(1) and 35(2).

Next, a method for manufacturing the shunt resistor 3A will be described.

The manufacturing method differs from the first manufacturing method for the shunt resistor 1A according to the first embodiment in that first and second conductive metal plates 134(1) and 134(2) are used instead of the first and second conductive metal plates 130(1) and 130(2).

The first conductive metal plate 134(1) includes, in addition to the first conductor forming region 140(1) and the first inner extending region 150(1), a first outer extending region 154(1) connected to the first conductor forming region 140(1) with a first outer boundary 146(1) interposed therebetween (refer to Fig. 18).

Similarly, the second conductive metal plate 134(2) includes, in addition to the second conductor forming region 140(2) and the second inner extending region 150(2), a second outer extending region 154(2) connected to the second conductor forming region 140(2) with a second outer boundary 146(2) interposed therebetween (refer to Fig. 18).

Compared to the first manufacturing method for the shunt resistor 1A according to the first embodiment, the method for manufacturing the shunt resistor 3A forms first and second through holes 180(1) and 180(2) instead of the first and second through holes 160(1) and 160(2).

As illustrated in Fig. 19, the first through hole 180(1) includes a first slit forming part 182(1) for forming the first slit 80(1), a first end side extending part 184(1) extending from a first end of the first slit forming part 182(1) on one end side into the first inner extending region 150(1) beyond the first inner boundary 142(1) and terminating inside the first inner extending region 150(1), and a second end side extending part 186(1) extending from a second end of the first slit forming part 182(1) on the other end side into the first outer extending region 154(1) beyond the first outer boundary 146(1) and terminating inside the first outer extending region 154(1).

Similarly, the second through hole 180(2) includes a second slit forming part 182(2) for forming the second slit 80(2), a first end side extending part 184(2) extending from a first end of the second slit forming part 182(2) on one end side into the second inner extending region 150(2) beyond the second inner boundary 142(2) and terminating inside the second inner extending region 150(2), and a second end side extending part 186(2) extending from a second end of the second slit forming part 182(2) on the other end side into the second outer extending region 154(2) beyond the second outer boundary 146(2) and terminating inside the second outer extending region 154(2).

In the method for manufacturing the shunt resistor 3A, after coating for forming the first insulating resin 50(1) (the second insulating resin 50(2)) is applied to the first through hole 180(1) (the second through hole 180(2)) and cured (refer to Fig. 20), the first conductor forming region 140(1) (the second conductor forming region 140(2)) is cut out of the first conductive metal plate 134(1) (the second conductive metal plate 134(2)) at a cutting line including the first inner boundary 142(1) (the second inner boundary 142(2)) and the first outer boundary 146(1) (the second outer boundary 146(2)) (refer to Fig. 21).

Figs. 22 to 25 are plan views of shunt resistors 9A to 9D according to first to fourth reference examples, respectively.

Note that, in the drawings, members same as those in the first to third embodiments will be designated by the same reference signs as in the first to third embodiments.

The shunt resistors 9A to 9D according to the first to fourth reference examples cannot ensure sufficient insulating properties between the current region and the voltage detecting connection portion.

In the first reference example 9A illustrated in Fig. 22, a first slit 210(1) (a second slit 210 (2)) formed on the first conductor 20(1) (the second conductor 20(2)) extends parallel to the longitudinal direction L corresponding to the current flowing direction, and has a first end 211(1) (211(2)) on one end side in plan view, the first end 211(1) (211(2)) being open on the inner end face 21(1) (21(2)), and a second end 212 (1) (212(2)) on the other end side in plan view, the second end 212 (1) (212(2)) extending toward the outer end face 22(1) (22(2)) beyond the first voltage detecting connection portion 37 (the second voltage detecting connection portion 37) in the longitudinal direction L and terminating inside the first conductor 20(1) (the second conductor 20(2)).

In the second reference example 9B illustrated in Fig. 23, a first slit 215(1) (a second slit 215 (2)) formed on the first conductor 20(1) (the second conductor 20(2)) extends parallel to the longitudinal direction L corresponding to the current flowing direction in such a manner as to overlap the voltage detecting connection portion in the longitudinal direction L, and has a first end 216(1) (216(2)) on one end side in plan view, the first end 216(1) (216(2)) terminating inside the first conductor 20(1) (the second conductor 20(2)) with a space left from the inner end face 21(1) (21(2)), and a second end 217 (1) (217(2)) on the other end side in plan view, the second end 217 (1) (217(2)) extending toward the outer end face 22(1) (22(2)) beyond the first voltage detecting connection portion 37 (the second voltage detecting connection portion 37) in the longitudinal direction L and terminating inside the first conductor 20(1) (the second conductor 20(2)).

In the third reference example 9C illustrated in Fig. 24, the first slit 215(1) (the second slit 215(2)) in the second reference example 9B is disposed on each side of the first voltage detecting connection portion 37 (the second voltage detecting connection portion 37) in the width direction W perpendicular to the longitudinal direction L.

In the fourth reference example 9D illustrated in Fig. 25, a first slit 220(1) (a second slit 220 (2)) formed on the first conductor 20(1) (the second conductor 20(2)) extends parallel to the longitudinal direction L corresponding to the current flowing direction and is disposed inside the first conductor 20(1) (the second conductor 20(2)) in such a manner as not to overlap the first voltage detecting connection portion 37 (the second voltage detecting portion 37) in the longitudinal direction L.

### Fourth Embodiment

Hereinbelow, another embodiment of the method for manufacturing the shunt resistor according to the present invention will be described with reference to the accompanying drawings.

Fig. 26A is a plan view of a shunt resistor 4A according to the present embodiment. Fig. 26B is a sectional view taken along line XXVI-XXVI in Fig. 26A.

Note that, in the drawings, members same as those in the first to third embodiments will be designated by the same reference signs as in the first to third embodiments to appropriately omit description thereof.

The shunt resistor 4A includes the resistive element 10, the first and second conductors 20(1) and 20(2), first and second voltage detecting connection portions (the pin electrodes 37 in the illustrated configuration) respectively provided on the first and second conductors 20(1) and 20(2), a first slit 90(1) penetrating the first conductor 20(1) from the upper face through the lower face, the first insulating resin 50(1) filling the first slit 90(1), a second slit 90(2) penetrating the second conductor 20(2) from the upper face through the lower face, and the second insulating resin 50(2) filling the second slit 90(2).

As illustrated in Fig. 26A, the first slit 90(1) is disposed in such a manner as to overlap the first voltage detecting connection portion and be shorter than half the width of the first conductor 20(1) in the width direction W perpendicular to the longitudinal direction L corresponding to the current flowing direction on the side farther away from the resistive element 10 than the first voltage detecting connection portion is in the longitudinal direction L.

Similarly, the second slit 90(2) is disposed in such a manner as to overlap the second voltage detecting connection portion and be shorter than half the width of the second conductor 20(2) in the width direction W perpendicular to the longitudinal direction L on the side farther away from the resistive element 10 than the second voltage detecting connection portion is in the longitudinal direction L.

The shunt resistor 4A having such a configuration can make the resistance value between the first and second voltage detecting connection portions equal to the resistance value of the resistive element 10 as accurately as possible without deteriorating the mechanical strength of the shunt resistor 4A.

Further, it is possible to reduce power loss caused by voltage measurement between the first and second voltage detecting connection portions.

Fig. 27Ais a plan view of a shunt resistor 4B according to a modification of the present embodiment. Fig. 27B is a sectional view taken along line XXVII-XXVII in Fig. 27A.

Compared to the shunt resistor 4A, the shunt resistor 4B includes first and second slits 90B(1) and 90B(2) instead of the first and second slits 90(1) and 90(2).

The first slit 90B(1) differs from the first slit 90(1) in that one end is open on one of the first and second side faces 23(1) and 24(1) (the first side face 23(1) in the illustrated configuration).

Similarly, the second slit 90B(2) differs from the second slit 90(2) in that one end is open on one of the first and second side faces 23(2) and 24(2) (the first side face 23(2) in the illustrated configuration).

The shunt resistor 4B can more accurately make the resistance value between the first and second voltage detecting connection portions equal to the resistance value of the resistive element 10.

Note that, although the pin electrodes 37 are provided as the first and second voltage detecting connection portions in the present embodiment 4A and the modification 4B, it is needless to say that the connection openings 32 can be provided instead of the pin electrodes 37.

### DESCRIPTION OF THE REFERENCE NUMERALS

- 1A- 4B: shunt resistor
- 10: resistive element
- 11(1), 11(2): first and second joint faces
- 20(1), 20(2): first and second conductors
- 21(1), 21(2): inner end faces of the first and second conductors
- 22(1), 22(2): outer end faces of the first and second conductors
- 23(1), 23(2): first side faces of the first and second conductors
- 24(1), 24(2): second side faces of the first and second conductors
- 30(1), 30(2): first and second current regions
- 32: fastening hole
- 35(1), 35(2): first and second voltage regions
- 37: pin electrode
- 39: connection opening
- 40(1)- 40D(1): first slit
- 40(2)- 40D(2): second slit
- 45(1), 45C(1), 45D(1): first part of the first slit
- 45(2), 45C(2), 45D(2): first part of the second slit
- 46(1), 46C(1), 46D(1): second part of the first slit
- 46(2), 46C(2), 46D(2): second part of the second slit
- 47(1), 47C(1), 47D(1): coupling part of the first slit
- 47(2), 47C(2), 47D(2): coupling part of the second slit
- 50(1), 50(2): first and second insulating resins
- 70(1), 80(1), 90(1), 90B(1): first slit
- 70(2), 80(2), 90(2), 90B(2): second slit
- 120(1), 120(2): first and second conductor assemblies
- 130(1), 130(2): first and second conductive metal plates
- 140(1), 140(2): first and second conductor forming regions
- 142(1), 142(2): first and second inner boundaries
- 144(1), 144(2): first and second lateral boundaries
- 146(1), 146(2): first and second outer boundaries
- 150(1), 150(2): first and second inner extending regions
- 152(1), 152(2): first and second lateral extending regions
- 154(1), 154(2): first and second outer extending regions
- 160(1), 170(1), 180(1): first through hole
- 160(2), 170(2), 180(2): second through hole
- 162(1), 172(1), 182(1): first slit forming part
- 162(2), 172(2), 182(2): second slit forming part
- 164(1), 174(1), 184(1): first end side extending part of the first through hole
- 164(2), 174(2), 184(2): first end side extending part of the second through hole
- 166(1), 176(1), 186(1): second end side extending part of the first through hole
- 166(2), 176(2), 186(2): second end side extending part of the second through hole

## Claims

1. A shunt resistor (1A-1D) comprising:
a resistive element (10) having a plate-like shape, the resistive element (10) having a first joint face (11(1)) and a second joint face (11(2)) respectively located on one side and the other side in a longitudinal direction corresponding to a current flowing direction and having a predetermined resistance value;
a first conductor (20(1)) having an inner end face (21(1)) joined to the first joint face (11(1));
a second conductor (20(2)) having an inner end face (21(2)) joined to the second joint face (11(2));
a first slit (40(1), 40C(1), 40D(1)) separating the first conductor (20(1)) into a first current region (30(1)) and a first voltage region (35(1));
a first insulating resin (50(1)) filling the first slit (40(1), 40C(1), 40D(1));
a second slit (40(2), 40C(2), 40D(2)) separating the second conductor (20(2)) into a second current region (30(2)) and a second voltage region (35(2)); and
a second insulating resin (50(2)) filling the second slit (40(2), 40C(2), 40D(2)), wherein
the first slit (40(1), 40C(1), 40D(1)) has a first end (41(1)) on one end side and a second end (42(1)) on the other end side, the first end (41(1)) being open on the inner end face (21(1)) of the first conductor (20(1)) and the second end (42(1)) being open on the inner end face (21(1)) of the first conductor (20(1)) at a position that makes a joint area between the first voltage region (35(1)) and the resistive element (10) smaller than a joint area between the first current region (30(1) and the resistive element (10) so that the first current region (30(1)) and the first voltage region (35(1)) both have a region joined to the first joint face (11(1)), and
the second slit (40(2), 40C(2), 40D(2)) has a first end (41(2); 71(2); 81(2)) on one end side and a second end (42(2)) on the other end side, the first end (41(2)) being open on the inner end face (21(2)) of the second conductor (20(2)) and the second end (42(2)) being open on the inner end face (21(2)) of the second conductor (20(2)) at a position that makes a joint area between the second voltage region (35(2)) and the resistive element (10) smaller than a joint area between the second current region (30(2)) and the resistive element (10) so that the second current region (30(2)) and the second voltage region (35(2)) both have a region in contact with the second joint face (11(2)).

2. The shunt resistor (1C-1D) according to claim 1, wherein
the first conductor (20(1) has an outer end face (22(1)) located opposite to the inner end face (21(1)) in the longitudinal direction, and a first side face (23(1)) and a second side face (24(1)) respectively located on one side and the other side in a width direction perpendicular to the longitudinal direction,
the second conductor (20(2)) has an outer end face (22(2)) located opposite to the inner end face (21(2)) in the longitudinal direction, and a first side face (23(2)) and a second side face (24(2)) respectively located on the one side and the other side in the width direction,
the first slit (40C(1), 40D(1)) includes a first part (45C(1), 45D(1)) extending from one of the first and second ends (41(1), 42(1)) closer to the first side face (23(1)) of the first conductor (20(1)) than the other is in such a manner as to be closer to the first side face (23(1)) of the first conductor (20(1)) toward the outer end face (22(1)) of the first conductor (20(1)) and terminating inside the first conductor (20(1)), a second part (46C(1), 46D(1)) extending from one of the first and second ends (41(1), 42(1)) closer to the second side face (24(1)) of the first conductor (20(1)) than the other is in such a manner as to be closer to the second side face (24(1)) of the first conductor (20(1)) toward the outer end face (22(1)) of the first conductor (20(1)) and terminating inside the first conductor (20(1)), and a coupling part (47C(1), 47D(1)) coupling the first and second parts (45C(1), 45D(1); 46C(1), 46D(1)), and
the second slit (40C(2), 40D(2)) includes a first part (45C(2), 45D(2)) extending from one of the first and second ends (41(2), 42(2)) closer to the first side face (23(2)) of the second conductor (20(2)) than the other is in such a manner as to be closer to the first side face (23(2)) of the second conductor (20(2)) toward the outer end face (22(2)) of the second conductor (20(2)) and terminating inside the second conductor (20(2)), a second part (46C(2), 46D(2)) extending from one of the first and second ends (41(2), 42(2)) closer to the second side face (24(2))of the second conductor (20(2)) than the other is in such a manner as to be closer to the second side face (24(2)) of the second conductor (20(2)) toward the outer end face (22(2)) of the second conductor (20(2)) and terminating inside the second conductor (20(2)), and a coupling part (47C(2), 47D(2)) coupling the first and second parts (45C(2), 45D(2); 46C(2), 46D(2)).

3. The shunt resistor (1A-1D) according to claim 1 or 2, wherein the first voltage region (35(1)) includes a pin electrode (37) constituting a first voltage detecting connection portion, and the second voltage region (35(2)) includes a pin electrode (37) constituting a second voltage detecting connection portion.

4. The shunt resistor (1A-1D) according to claim 1 or 2, wherein the first voltage region (35(1)) includes a connection opening (39) constituting a first voltage detecting connection portion, and the second voltage region (35(2)) includes a connection opening (39) constituting a second voltage detecting connection portion.

5. The shunt resistor (1A-1D) according to any one of claims 1 to 4, wherein each of the first and second conductors (20(1), 20(2)) includes a fastening hole (32).

6. A method for manufacturing a shunt resistor (1A-1D) according to claim 1, comprising:
a step of preparing the resistive element (10), a first conductor assembly (120(1)) including the first conductor (20(1)), the first slit (40(1), 40C(1), 40D(1)) and the first insulating resin (50(1)), and a second conductor assembly (120(2)) including the second conductor(20(2)), the second slit (40(2), 40C(2), 40D(2)) and the second insulating resin (50(2));
a first conductor joining step of joining the inner end face (21(1)) of the first conductor (20(1)) of the first conductor assembly (120(1)) and the first joint face (11(1)) of the resistive element (10) together in an abutting state; and
a second conductor joining step of joining the inner end face (21(2)) of the second conductor (20(2)) of the second conductor assembly (120(2)) and the second joint face (11(2)) of the resistive element (10) together in an abutting state,
wherein the first conductor assembly (120(1)) is formed by:
a step of preparing a first conductive metal plate (130(1)) including a first conductor forming region (140(1)) for forming the first conductor (20(1)) and a first inner extending region (150(1)) connected to the first conductor forming region (140(1)) with a first inner boundary (142(1)) defining a position of the inner end face (21(1)) interposed therebetween;
a step of forming a first through hole (160(1)) on the first conductive metal plate (130(1)), the first through hole (160(1)) penetrating the first conductive metal plate (130(1)) from an upper face on one side in a thickness direction through a lower face on other side in the thickness direction and including a first slit forming part (162(1)) having a plan-view shape inside the first conductor forming region (140(1)) identical to a plan-view shape of the first slit (40(1), 40C(1), 40D(1)) and a first end side extending part (164(1)) extending from a first end of the first slit forming part (162(1)) on one end side into the first inner extending region (150(1)) beyond the first inner boundary (142(1)) and terminating inside the first inner extending region (150(1));
a step of applying coating containing an insulating resin material to inside of the first through hole (160(1)) and curing the coating to fill the first through hole (160(1)) with the first insulating resin (50(1)); and
a step of cutting the first conductor forming region (140(1)) out of the first conductive metal plate (130(1)) at a cutting line including the first inner boundary (142(1)) to obtain the first conductor assembly (120(1)) including the first conductor (20(1)), the first slit (40(1), 40C(1), 40D(1)) and the first insulating resin (50(1)), and
wherein the second conductor assembly (120(2)) is formed by:
a step of preparing a second conductive metal plate (130(2)) including a second conductor forming region (140(2)) for forming the second conductor (20(2)) and a second inner extending region (150(2)) connected to the second conductor forming region (140(2)) with a second inner boundary (142(2)) defining a position of the inner end face (21(2)) interposed therebetween;
a step of forming a second through hole (160(2)) on the second conductive metal plate (130(2)), the second through hole (160(2)) penetrating the second conductive metal plate (130(2)) from an upper face on one side in a thickness direction through a lower face on other side in the thickness direction and including a second slit forming part (162(2)) having a plan-view shape inside the second conductor forming region (140(2)) identical to a plan-view shape of the second slit (40(2), 40C(2), 40D(2)) and a first end side extending part (164(2)) extending from a first end of the second slit forming part (162(2)) on one end side into the second inner extending region (150(2)) beyond the second inner boundary (142(2)) and terminating inside the second inner extending region (150(2));
a step of applying coating containing an insulating resin material to inside of the second through hole (160(2)) and curing the coating to fill the second through hole (160(2)) with the second insulating resin (50(2)); and
a step of cutting the second conductor forming region (140(2)) out of the second conductive metal plate (130(2)) at a cutting line including the second inner boundary (142(2)) to obtain the second conductor assembly (120(2)) including the second conductor (20(2)), the second slit (40(2), 40C(2), 40D(2)) and the second insulating resin (50(2)).

7. The method for manufacturing the shunt resistor (1A-1D) according to claim 6, wherein
the first slit (40(1), 40C(1), 40D(1)) has a second end (42(1)) on the other end side, the second end (42(1)) being open on the inner end face (21(1)) of the first conductor (20(1)), and the second slit (40(2), 40C(2), 40D(2)) has a second end (42(2)) on the other end side, the second end (42(2)) being open on the inner end face (21(2)) of the second conductor (20(2)),
the first through hole (160(1)) includes, in addition to the first slit forming part (162(1)) and the first end side extending part (164(1)), a second end side extending part (166(1)) extending from a second end of the first slit forming part (162(1)) on the other end side into the first inner extending region (150(1)) beyond the first inner boundary (142(1)) and terminating inside the first inner extending region (150(1)), and
the second through hole (160(2)) includes, in addition to the second slit forming part (162(2)) and the first end side extending part (164(2)), a second end side extending part (166(2)) extending from a second end of the second slit forming part (162(2)) on the other end side into the second inner extending region (150(2)) beyond the second inner boundary (142(2)) and terminating inside the second inner extending region (150(2)).

## Patentansprüche

1. Nebenschlusswiderstand (1A-1D), umfassend:
ein Widerstandselement (10), das eine plattenartige Form aufweist, wobei das Widerstandselement (10) eine erste Verbindungsfläche (11(1)) und eine zweite Verbindungsfläche (11(2)) aufweist, die sich auf der einen Seite bzw. der anderen Seite in einer Längsrichtung entsprechend einer Stromflussrichtung befinden und einen zuvor festgelegten Widerstandswert aufweisen;
einen ersten Leiter (20(1)), der eine innere Endfläche (21(1)) aufweist, die mit der ersten Verbindungsfläche (11(1)) verbunden ist;
einen zweiten Leiter (20(2)), der eine innere Endfläche (21(2)) aufweist, die mit der zweiten Verbindungsfläche (11(2)) verbunden ist;
einen ersten Schlitz (40(1), 40C(1), 40D(1)), der den ersten Leiter (20(1)) in eine erste Stromregion (30(1)) und eine erste Spannungsregion (35(1)) unterteilt;
ein erstes Isolierharz (50(1)), das den ersten Schlitz (40(1), 40C(1), 40D(1)) füllt;
einen zweiten Schlitz (40(2), 40C(2), 40D(2)), der den zweiten Leiter (20(2)) in eine zweite Stromregion (30(2)) und eine zweite Spannungsregion (35(2)) unterteilt; und
ein zweites Isolierharz (50(2)), das den zweiten Schlitz (40(2), 40C(2), 40D(2)) füllt, wobei
der erste Schlitz (40(1), 40C(1), 40D(1)) ein erstes Ende (41(1)) auf der einen Endseite und ein zweites Ende (42(1)) auf der anderen Endseite aufweist, wobei das erste Ende (41(1)) an der inneren Endfläche (21(1)) des ersten Leiters (20(1)) offen ist und das zweite Ende (42(1)) an der inneren Endfläche (21(1)) des ersten Leiters (20(1)) an einer Position offen ist, die einen Verbindungsbereich zwischen der ersten Spannungsregion (35(1)) und dem Widerstandselement (10) kleiner macht als einen Verbindungsbereich zwischen der ersten Stromregion (30(1)) und dem Widerstandselement (10), so dass die erste Stromregion (30(1)) und die erste Spannungsregion (35(1)) beide eine Region aufweisen, der mit der ersten Verbindungsfläche (11(1)) verbunden ist, und
der zweite Schlitz (40(2), 40C(2), 40D(2)) ein erstes Ende (41(2); 71(2); 81(2)) auf der einen Endseite und ein zweites Ende (42(2)) auf der anderen Endseite aufweist, wobei das erste Ende (41(2)) an der inneren Endfläche (21(2)) des zweiten Leiters (20(2)) offen ist und das zweite Ende (42(2)) an der inneren Endfläche (21(2)) des zweiten Leiters (20(2)) an einer Position offen ist, die einen Verbindungsbereich zwischen der zweiten Spannungsregion (35(2)) und dem Widerstandselement (10) kleiner macht als einen Verbindungsbereich zwischen der zweiten Stromregion (30(2)) und dem Widerstandselement (10), so dass die zweite Stromregion (30(2)) und die zweite Spannungsregion (35(2)) beide eine Region in Kontakt mit der zweiten Verbindungsfläche (11(2)) aufweisen.

2. Nebenschlusswiderstand (1C-1D) nach Anspruch 1, wobei
der erste Leiter (20(1) eine äußere Endfläche (22(1)) aufweist, die der inneren Endfläche (21(1)) in der Längsrichtung gegenüberliegt, und eine erste Seitenfläche (23(1)) und eine zweite Seitenfläche (24(1)) aufweist, die sich auf der einen Seite bzw. der anderen Seite in einer Breitenrichtung senkrecht zu der Längsrichtung befindet,
der zweite Leiter (20(2)) eine äußere Endfläche (22(2)) aufweist, die der inneren Endfläche (21(2)) in der Längsrichtung gegenüberliegt, und eine erste Seitenfläche (23(2)) und eine zweite Seitenfläche (24(2)) aufweist, die sich auf der einen Seite bzw. der anderen Seite in der Breitenrichtung befinden,
der erste Schlitz (40C(1), 40D(1)) einen ersten Teil (45C(1), 45D(1)) aufweist, der sich von einem des ersten und des zweiten Endes (41(1)), 42(1)) erstreckt, das näher bei der ersten Seitenfläche (23(1)) des ersten Leiters (20(1)) liegt als das andere, dergestalt, dass er in Richtung der äußeren Endfläche (22(1)) des ersten Leiters (20(1)) näher bei der ersten Seitenfläche (23(1)) des ersten Leiters (20(1)) liegt und im Inneren des ersten Leiters (20(1)) endet, einen zweiten Teil (46C(1), 46D(1)) aufweist, der sich von einem des ersten und des zweiten Endes (41(1)), 42(1)) erstreckt, das näher bei der zweiten Seitenfläche (24(1)) des ersten Leiters (20(1)) liegt als das andere, dergestalt, dass er in Richtung der äußeren Endfläche (22(1)) des ersten Leiters (20(1)) näher bei der zweiten Seitenfläche (24(1)) des ersten Leiters (20(1)) liegt und im Inneren des ersten Leiters (20(1)) endet, und einen Kopplungsteil (47C(1), 47D(1)) aufweist, der den ersten und den zweiten Teil (45C(1), 45D(1); 46C(1), 46D(1)) miteinander koppelt, und
der zweite Schlitz (40C(2), 40D(2)) einen ersten Teil (45C(2), 45D(2)) aufweist, der sich von einem des ersten und des zweiten Endes (41(2)), 42(2)) erstreckt, das näher bei der ersten Seitenfläche (23(2)) des zweiten Leiters (20(2)) liegt als das andere, dergestalt, dass er in Richtung der äußeren Endfläche (22(2)) des zweiten Leiters (20(2)) näher bei der ersten Seitenfläche (23(2)) des ersten Leiters (20(2)) liegt und im Inneren des zweiten Leiters (20(2)) endet, einen zweiten Teil (46C(2), 46D(2)) aufweist, der sich von einem des ersten und des zweiten Endes (41(2)), 42(2)) erstreckt, das näher bei der zweiten Seitenfläche (24(2)) des zweiten Leiters (20(2)) liegt als das andere, dergestalt, dass er in Richtung der äußeren Endfläche (22(2)) des zweiten Leiters (20(2)) näher bei der zweiten Seitenfläche (24(2)) des zweiten Leiters (20(2)) liegt und im Inneren des zweiten Leiters (20(2)) endet, und einen Kopplungsteil (47C(2), 47D(2)) aufweist, der den ersten und den zweiten Teil (45C(2), 45D(2); 46C(2), 46D(2)) miteinander koppelt.

3. Nebenschlusswiderstand (1A-1D) nach Anspruch 1 oder 2, wobei die erste Spannungsregion (35(1)) eine Stiftelektrode (37) aufweist, die einen ersten Spannungsdetektionsverbindungsabschnitt bildet, und die zweite Spannungsregion (35(2)) eine Stiftelektrode (37) aufweist, die einen zweiten Spannungsdetektionsverbindungsabschnitt bildet.

4. Nebenschlusswiderstand (1A-1D) nach Anspruch 1 oder 2, wobei die erste Spannungsregion (35(1)) eine Verbindungsöffnung (39) aufweist, die einen ersten Spannungsdetektionsverbindungsabschnitt bildet, und die zweite Spannungsregion (35(2)) eine Verbindungsöffnung (39) aufweist, die einen zweiten Spannungsdetektionsverbindungsabschnitt bildet.

5. Nebenschlusswiderstand (1A-1D) nach einem der Ansprüche 1 bis 4, wobei jeder des ersten und des zweiten Leiters (20(1), 20(2)) ein Befestigungsloch (32) aufweist.

6. Verfahren zur Herstellung eines Nebenschlusswiderstands (1A-1D) nach Anspruch 1, umfassend:
einen Schritt des Vorbereitens des Widerstandselements (10), einer ersten Leiteranordnung (120(1)), die den ersten Leiter (20(1)), den ersten Schlitz (40(1), 40C(1), 40D(1)) und das erste Isolierharz (50(1)) aufweist, und einer zweiten Leiteranordnung (120(2)), die den zweiten Leiter (20(2)), den zweiten Schlitz (40(2), 40C(2), 40D(2)) und das zweite Isolierharz (50(2)) aufweist;
einen Erster-Leiter-Verbindungsschritt des Verbindens der inneren Endfläche (21(1)) des ersten Leiters (20(1)) der ersten Leiteranordnung (120(1)) und der ersten Verbindungsfläche (11(1)) des Widerstandselements (10) in einem aneinanderstoßenden Zustand miteinander; und
einen Zweiter-Leiter-Verbindungsschritt des Verbindens der inneren Endfläche (21(2)) des zweiten Leiters (20(2)) der zweiten Leiteranordnung (120(2)) und der zweiten Verbindungsfläche (11(2)) des Widerstandselements (10) in einem aneinanderstoßenden Zustand miteinander,
wobei die erste Leiteranordnung (120(1)) gebildet wird durch:
einen Schritt des Vorbereitens einer ersten leitfähigen Metallplatte (130(1)), aufweisend eine erste Leiterbildungsregion (140(1)) zum Bilden des ersten Leiters (20(1)) und eine erste innere Erstreckungsregion (150(1)), die mit der ersten Leiterbildungsregion (140(1)) verbunden ist, wobei eine erste innere Begrenzung (142(1)) eine Position der inneren Endfläche (21(1)), die dazwischen angeordnet ist, definiert;
einen Schritt des Bildens eines ersten Durchgangslochs (160(1)) in der ersten leitfähigen Metallplatte (130(1)), wobei das erste Durchgangsloch (160(1)) die erste leitfähige Metallplatte (130(1)) von einer Oberseite auf einer Seite in einer Dickenrichtung durch eine Unterseite auf der anderen Seite in der Dickenrichtung durchdringt und einen ersten Schlitzbildungsteil (162(1)), dessen Draufsichtform im Inneren der ersten Leiterbildungsregion (140(1)) identisch ist mit einer Draufsichtform des ersten Schlitzes (40(1), 40C(1), 40D(1)), und einen ersten endseitigen Erstreckungsteil (164(1)), der sich von einem ersten Ende des ersten Schlitzbildungsteils (162(1)) auf einer Endseite in die erste innere Erstreckungsregion (150(1)) über die erste innere Begrenzung (142(1)) hinaus erstreckt und im Inneren der ersten inneren Erstreckungsregion (150(1)) endet, aufweist;
einen Schritt des Aufbringens einer Beschichtung, die ein isolierendes Harzmaterial enthält, auf die Innenseite des ersten Durchgangslochs (160(1)), und des Aushärtens der Beschichtung, um das erste Durchgangsloch (160(1)) mit dem ersten Isolierharz (50(1)) zu füllen; und
einen Schritt des Ausschneidens der ersten Leiterbildungsregion (140(1)) aus der ersten leitfähigen Metallplatte (130(1)) an einer Schnittlinie, die die erste innere Begrenzung (142(1)) enthält, um die erste Leiteranordnung (120(1)) zu erhalten, die den ersten Leiter (20(1)), den ersten Schlitz (40(1), 40C(1), 40D(1)) und das erste Isolierharz (50(1)) aufweist, und
wobei die zweite Leiteranordnung (120(2)) gebildet wird durch:
einen Schritt des Vorbereitens einer zweiten leitfähigen Metallplatte (130(2)), aufweisen eine zweite Leiterbildungsregion (140(2)) zum Bilden des zweiten Leiters (20(2)) und eine zweite innere Erstreckungsregion (150(2)), die mit der zweiten Leiterbildungsregion (140(2)) verbunden ist, wobei eine zweite innere Begrenzung (142(2)) eine Position der inneren Endfläche (21(2)), die dazwischen angeordnet ist, definiert;
einen Schritt des Bildens eines zweiten Durchgangslochs (160(2)) in der zweiten leitfähigen Metallplatte (130(2)), wobei das zweite Durchgangsloch (160(2)) die zweite leitfähige Metallplatte (130(2)) von einer Oberseite auf einer Seite in einer Dickenrichtung durch eine Unterseite auf der anderen Seite in der Dickenrichtung durchdringt und einen zweiten Schlitzbildungsteil (162(2)), dessen Draufsichtform im Inneren der zweiten Leiterbildungsregion (140(2)) identisch ist mit einer Draufsichtform des zweiten Schlitzes (40(2), 40C(2), 40D(2)), und einen ersten endseitigen Erstreckungsteil (164(2)), der sich von einem ersten Ende des zweiten Schlitzbildungsteils (162(2)) auf einer Endseite in die zweite innere Erstreckungsregion (150(2)) über die zweite innere Begrenzung (142(2)) hinaus erstreckt und im Inneren der zweiten inneren Erstreckungsregion (150(2)) endet, aufweist;
einen Schritt des Aufbringens einer Beschichtung, die ein isolierendes Harzmaterial enthält, auf die Innenseite des zweiten Durchgangslochs (160(2)), und des Aushärtens der Beschichtung, um das zweite Durchgangsloch (160(2)) mit dem zweiten Isolierharz (50(2)) zu füllen; und
einen Schritt des Ausschneidens der zweiten Leiterbildungsregion (140(2)) aus der zweiten leitfähigen Metallplatte (130(2)) an einer Schnittlinie, die die zweite innere Begrenzung (142(2)) enthält, um die zweite Leiteranordnung (120(2)) zu erhalten, die den zweiten Leiter (20(2)), den zweiten Schlitz (40(2), 40C(2), 40D(2)) und das zweite Isolierharz (50(2)) aufweist.

7. Verfahren zur Herstellung des Nebenschlusswiderstands (1A-1D) nach Anspruch 6, wobei:
der erste Schlitz (40(1), 40C(1), 40D(1)) ein zweites Ende (42(1)) auf der anderen Endseite aufweist, wobei das zweite Ende (42(1)) an der inneren Endfläche (21(1)) des ersten Leiters (20(1)) offen ist, und der zweite Schlitz (40(2), 40C(2), 40D(2)) ein zweites Ende (42(2)) auf der anderen Endseite aufweist, wobei das zweite Ende (42(2)) an der inneren Endfläche (21(2)) des zweiten Leiters (20(2)) offen ist,
das erste Durchgangsloch (160(1)) zusätzlich zu dem ersten Schlitzbildungsteil (162(1)) und dem ersten endseitigen Erstreckungsteil (164(1)) einen zweiten endseitigen Erstreckungsteil (166(1)) aufweist, der sich von einem zweiten Ende des ersten Schlitzbildungsteils (162(1)) auf der anderen Endseite in die erste innere Erstreckungsregion (150(1)) über die erste innere Begrenzung (142(1)) hinaus erstreckt und im Inneren der ersten inneren Erstreckungsregion (150(1)) endet, und
das zweite Durchgangsloch (160(2)) zusätzlich zu dem zweiten Schlitzbildungsteil (162(2)) und dem ersten endseitigen Erstreckungsteil (164(2)) einen zweiten endseitigen Erstreckungsteil (166(2)) aufweist, der sich von einem zweiten Ende des zweiten Schlitzbildungsteils (162(2)) auf der anderen Endseite in die zweite innere Erstreckungsregion (150(2)) über die zweite innere Begrenzung (142(2)) hinaus erstreckt und im Inneren der zweiten inneren Erstreckungsregion (150(2)) endet.

## Revendications

1. Résistance shunt (1A-1D) comprenant :
un élément résistif (10) ayant une forme de plaque, l'élément résistif (10) ayant une première face de liaison (11(1)) et une seconde face de liaison (11(2)) respectivement situées d'un côté et de l'autre côté dans une direction longitudinale correspondant à une direction de circulation de courant et ayant une valeur de résistance prédéterminée ;
un premier conducteur (20(1)) ayant une face d'extrémité intérieure (21(1)) reliée à la première face de liaison (11(1)) ;
un second conducteur (20(2)) ayant une face d'extrémité intérieure (21(2)) reliée à la seconde face de liaison (11(2)) ;
une première fente (40(1), 40C(1), 40D(1)) divisant le premier conducteur (20(1)) en une première zone de courant (30(1)) et une première zone de tension (35(1)) ;
une première résine isolante (50(1)) remplissant la première fente (40(1), 40C(1), 40D(1)) ;
une seconde fente (40(2), 40C(2), 40D(2)) divisant le second conducteur (20(2)) en une seconde zone de courant (30(2)) et une seconde zone de tension (35(2)) ; et
une seconde résine isolante (50(2)) remplissant la seconde fente (40(2), 40C(2), 40D(2)), dans laquelle
la première fente (40(1), 40C(1), 40D(1)) a une première extrémité (41(1)) d'un côté d'extrémité et une seconde extrémité (42(1)) de l'autre côté d'extrémité, la première extrémité (41(1)) étant ouverte sur la face d'extrémité intérieure (21(1)) du premier conducteur (20(1)) et la seconde extrémité (42(1)) étant ouverte sur la face d'extrémité intérieure (21(1)) du premier conducteur (20(1)) à une position qui rend une zone de liaison entre la première zone de tension (35(1)) et l'élément résistif (10) plus petite qu'une zone de liaison entre la première zone de courant (30(1)) et l'élément résistif (10) de sorte que la première zone de courant (30(1)) et la première zone de tension (35(1)) ont toutes deux une zone reliée à la première face de liaison (11(1)), et
la seconde fente (40(2), 40C(2), 40D(2)) a une première extrémité (41(2) ; 71(2) ; 81(2)) d'un côté d'extrémité et une seconde extrémité (42(2)) de l'autre côté d'extrémité, la première extrémité (41(2)) étant ouverte sur la face d'extrémité intérieure (21(2)) du second conducteur (20(2)) et la seconde extrémité (42(2)) étant ouverte sur la face d'extrémité intérieure (21(2)) du second conducteur (20(2)) à une position qui rend une zone de liaison entre la seconde zone de tension (35(2)) et l'élément résistif (10) plus petite qu'une zone de liaison entre la seconde zone de courant (30(2)) et l'élément résistif (10) de sorte que la seconde zone de courant (30(2)) et la seconde zone de tension (35(2)) ont toutes deux une zone en contact avec la seconde face de liaison (11(2)).

2. Résistance shunt (1C-1D) selon la revendication 1, dans laquelle
le premier conducteur (20(1)) a une face d'extrémité extérieure (22(1)) située à l'opposé de la face d'extrémité intérieure (21(1)) dans la direction longitudinale, et une première face latérale (23(1)) et une seconde face latérale (24(1)) respectivement situées d'un côté et de l'autre côté dans une direction de largeur perpendiculaire à la direction longitudinale,
le second conducteur (20(2)) a une face d'extrémité extérieure (22(2)) située à l'opposé de la face d'extrémité intérieure (21(2)) dans la direction longitudinale, et une première face latérale (23(2)) et une seconde face latérale (24(2)) respectivement situées de part et d'autre dans la direction de largeur,
la première fente (40C(1), 40D(1)) comporte une première partie (45C(1), 45D(1)) s'étendant à partir d'une des première et seconde extrémités (41(1), 42(1)) plus près de la première face latérale (23(1)) du premier conducteur (20(1)) que l'autre ne l'est de telle manière qu'elle est plus près de la première face latérale (23(1)) du premier conducteur (20(1)) vers la face d'extrémité extérieure (22(1)) du premier conducteur (20(1)) et se terminant à l'intérieur du premier conducteur (20(1)), une seconde partie (46C(1), 46D(1)) s'étendant à partir d'une des première et seconde extrémités (41(1), 42(1)) plus près de la seconde face latérale (24(1)) du premier conducteur (20(1)) que l'autre ne l'est de telle manière qu'elle est plus près de la seconde face latérale (24(1)) du premier conducteur (20(1)) vers la face d'extrémité extérieure (22(1)) du premier conducteur (20(1)) et se terminant à l'intérieur du premier conducteur (20(1)), et une partie de couplage (47C(1), 47D(1)) couplant les première et seconde parties (45C(1), 45D(1) ; 46C(1), 46D(1)), et
la seconde fente (40C(2), 40D(2)) comporte une première partie (45C(2), 45D(2)) s'étendant à partir d'une des première et seconde extrémités (41(2), 42(2)) plus près de la première face latérale (23(2)) du second conducteur (20(2)) que l'autre ne l'est de telle manière qu'elle est plus près de la première face latérale (23(2)) du second conducteur (20(2)) vers la face d'extrémité extérieure (22(2)) du second conducteur (20(2)) et se terminant à l'intérieur du second conducteur (20(2)), une seconde partie (46C(2), 46D(2)) s'étendant à partir d'une des première et seconde extrémités (41(2), 42(2)) plus près de la seconde face latérale (24(2)) du second conducteur (20(2)) que l'autre ne l'est de telle manière qu'elle est plus près de la seconde face latérale (24(2)) du second conducteur (20(2)) vers la face d'extrémité extérieure (22(2)) du second conducteur (20(2)) et se terminant à l'intérieur du second conducteur (20(2)), et une partie de couplage (47C(2), 47D(2)) couplant les première et seconde parties (45C(2), 45D(2) ; 46C(2), 46D(2)).

3. Résistance shunt (1A-1D) selon la revendication 1 ou 2, dans laquelle la première zone de tension (35(1)) comporte une électrode à broche (37) constituant une première portion de connexion détectrice de tension, et la seconde zone de tension (35(2)) comporte une électrode à broche (37) constituant une seconde portion de connexion détectrice de tension.

4. Résistance shunt (1A-1D) selon la revendication 1 ou 2, dans laquelle la première zone de tension (35(1)) comporte une ouverture de connexion (39) constituant une première portion de connexion détectrice de tension, et la seconde zone de tension (35(2)) comporte une ouverture de connexion (39) constituant une seconde portion de connexion détectrice de tension.

5. Résistance shunt (1A-1D) selon l'une quelconque des revendications 1 à 4, dans laquelle chacun des premier et second conducteurs (20(1), 20(2)) comporte un trou de fixation (32).

6. Procédé de fabrication d'une résistance shunt (1A-1D) selon la revendication 1, comprenant :
une étape consistant à préparer l'élément résistif (10), un premier ensemble conducteur (120(1)) comportant le premier conducteur (20(1)), la première fente (40(1), 40C(1), 40D(1)) et la première résine isolante (50(1)), et un second ensemble conducteur (120(2)) comportant le second conducteur (20(2)), la seconde fente (40(2), 40C(2), 40D(2)) et la seconde résine isolante (50(2)) ;
une première étape de liaison de conducteur consistant à relier ensemble la face d'extrémité intérieure (21(1)) du premier conducteur (20(1)) du premier ensemble conducteur (120(1)) et la première face de liaison (11(1)) de l'élément résistif (10) dans un état en butée ; et
une seconde étape de liaison de conducteur consistant à relier ensemble la face d'extrémité intérieure (21(2)) du second conducteur (20(2)) du second ensemble conducteur (120(2)) et la seconde face de liaison (11(2)) de l'élément résistif (10) dans un état en butée,
dans lequel le premier ensemble conducteur (120(1)) est formé par :
une étape consistant à préparer une première plaque métallique conductrice (130(1)) comportant une première zone de formation de conducteur (140(1)) destinée à former le premier conducteur (20(1)) et une première zone d'extension intérieure (150(1) reliée à la première zone de formation de conducteur (140(1) avec une première frontière intérieure (142(1)) définissant une position de la face d'extrémité intérieure (21(1)) intercalée entre celles-ci ;
une étape consistant à former un premier trou traversant (160(1)) sur la première plaque métallique conductrice (130(1)), le premier trou traversant (160(1)) pénétrant dans la première plaque métallique conductrice (130(1)) à partir d'une face supérieure d'un côté dans une direction d'épaisseur à travers une face inférieure de l'autre côté dans la direction d'épaisseur et comportant une première partie de formation de fente (162(1)) ayant une forme en vue de dessus à l'intérieur de la première zone de formation de conducteur (140(1)) identique à une forme en vue de dessus de la première fente (40(1), 40C(1), 40D(1)) et une première partie d'extension de côté d'extrémité (164(1)) s'étendant à partir d'une première extrémité de la première partie de formation de fente (162(1)) sur un côté d'extrémité dans la première zone d'extension intérieure (150(1)) au-delà de la première frontière intérieure (142(1)) et se terminant à l'intérieur de la première zone d'extension intérieure (150(1)) ;
une étape consistant à appliquer un revêtement contenant un matériau en résine isolant sur un intérieur du premier trou traversant (160(1)) et durcir le revêtement pour remplir le premier trou traversant (160(1)) avec la première résine isolante (50(1)) ; et
une étape consistant à découper la première zone de formation de conducteur (140(1)) à l'extérieur de la première plaque métallique conductrice (130(1)) sur une ligne de coupe incluant la première frontière intérieure (142(1)) pour obtenir le premier ensemble conducteur (120(1)) comportant le premier conducteur (20(1)), la première fente (40(1), 40C(1), 40D(1)) et la première résine isolante (50(1)), et
dans lequel le second ensemble conducteur (120(2)) est formé par :
une étape consistant à préparer une seconde plaque métallique conductrice (130(2)) comportant une seconde zone de formation de conducteur (140(2)) destinée à former le second conducteur (20(2)) et une seconde zone d'extension intérieure (150(2)) reliée à la seconde zone de formation de conducteur (140(2)) avec une seconde frontière intérieure (142(2)) définissant une position de la face d'extrémité intérieure (21(2)) intercalée entre celles-ci ;
une étape consistant à former un second trou traversant (160(2)) sur la seconde plaque métallique conductrice (130(2)), le second trou traversant (160(2)) pénétrant dans la seconde plaque métallique conductrice (130(2)) à partir d'une face supérieure d'un côté dans une direction d'épaisseur à travers une face inférieure de l'autre côté dans la direction d'épaisseur et comportant une seconde partie de formation de fente (162(2)) ayant une forme en vue de dessus à l'intérieur de la seconde zone de formation de conducteur (140(2)) identique à une forme en vue de dessus de la seconde fente (40(2), 40C(2), 40D(2)) et une première partie d'extension de côté d'extrémité (164(2)) s'étendant à partir d'une première extrémité de la seconde partie de formation de fente (162(2)) sur un côté d'extrémité dans la seconde zone d'extension intérieure (150(2)) au-delà de la seconde frontière intérieure (142(2)) et se terminant à l'intérieur de la seconde zone d'extension intérieure (150(2)) ;
une étape consistant à appliquer un revêtement contenant un matériau en résine isolant sur un intérieur du second trou traversant (160(2)) et durcir le revêtement pour remplir le second trou traversant (160(2)) avec la seconde résine isolante (50(2)) ; et
une étape consistant à découper la seconde zone de formation de conducteur (140(2)) à l'extérieur de la seconde plaque métallique conductrice (130(2)) sur une ligne de coupe incluant la seconde frontière intérieure (142(2)) pour obtenir le second ensemble conducteur (120(2)) comportant le second conducteur (20(2)), la seconde fente (40(2), 40C(2), 40D(2)) et la seconde résine isolante (50(2)).

7. Procédé de fabrication de la résistance shunt (1A-1D) selon la revendication 6, dans lequel
la première fente (40(1), 40C(1), 40D(1)) a une seconde extrémité (42(1)) de l'autre côté d'extrémité, la seconde extrémité (42(1)) étant ouverte sur la face d'extrémité intérieure (21(1)) du premier conducteur (20(1)), et la seconde fente (40(2), 40C(2), 40D(2)) a une seconde extrémité (42(2)) de l'autre côté d'extrémité, la seconde extrémité (42(2)) étant ouverte sur la face d'extrémité intérieure (21(2)) du second conducteur (20(2)),
le premier trou traversant (160(1)) comporte, en plus de la première partie de formation de fente (162(1)) et de la première partie d'extension de côté d'extrémité (164(1)), une seconde partie d'extension de côté d'extrémité (166(1)) s'étendant à partir d'une seconde extrémité de la première partie de formation de fente (162(1)) de l'autre côté d'extrémité dans la première zone d'extension intérieure (150(1)) au-delà de la première frontière intérieure (142(1)) et se terminant à l'intérieur de la première zone d'extension intérieure (150(1)), et
le second trou traversant (160(2)) comporte, en plus de la second partie de formation de fente (162(2)) et de la première partie d'extension de côté d'extrémité (164(2)), une seconde partie d'extension de côté d'extrémité (166(2)) s'étendant à partir d'une seconde extrémité de la seconde partie de formation de fente (162(2)) de l'autre côté d'extrémité dans la seconde zone d'extension intérieure (150(2)) au-delà de la seconde frontière intérieure (142(2)) et se terminant à l'intérieur de la seconde zone d'extension intérieure (150(2)).
